# EUROPEAN PATENT SPECIFICATION

(11) **EP 2 383 808 B1**
(45) Date of publication and mention of the grant of the patent: **29.08.2018**
(21) Application number: 11164125.4
(22) Date of filing: 28.04.2011
(51) Int. Cl.: H01L 33/62, H01L 23/00, H01L 33/48

(54) **Light emitting device package having leads with a recess for the chip mount area, and corresponding manufacturing methods**
Lichtemittierende Vorrichtung mit einer Vertiefung in den Leitern für den Montagebereich des Chips, und entspechende Herstellungsverfahren
Dispositif électroluminescent avec conducteurs ayant un évidement pour la surface de montage de la puce, et procédés de fabrication correspondants

(30) Priority: 30.04.2010 JP 2010105093
(43) Date of publication of application: 02.11.2011
(73) Proprietor: Nichia Corporation, Anan-shi Tokushima 774-8601 (JP)
(72) Inventor: Hayashi, Masaki, Anan-shi Tokushima 774-8601 (JP); Kuramoto, Masafumi, Anan-shi Tokushima 774-8601 (JP)
(74) Representative: Vossius & Partner Patentanwälte Rechtsanwälte mbB

(56) References cited:
- JP-A- 2005 294 736
- JP-A- 2009 295 883
- US-A1- 2004 159 850
- US-A1- 2007 145 403
- US-A1- 2008 224 161

## Description

The present invention relates to a light emitting device which can be used in indicator, lighting apparatus, display, backlight of liquid crystal display, auxiliary light source for lighting, etc. , and a method of manufacturing the light emitting device.

In recent years, various semiconductor devices have been proposed and are put in practical use, and the demand for high performance is ever increasing. Among semiconductor devices, light emitting devices, light emitting diodes (LEDs) in particular, are facing demands for much higher optical output (higher brightness) and further improvement in reliability, at the same time providing stable supply at a low price while fulfilling such improved features.

Conventionally, there has been proposed a light emitting device which includes a package substrate having a resin portion made of a thermosetting resin integrally molded with a printed wiring board which has a metal wiring, an LED element housed in a recess provided in a top surface side of the package substrate, and a transparent sealing resin filled in the recess to cover the LED element (see for example JP2007-235085A) . In the light emitting device described in JP 2007-235085A, the metal wiring is disposed to be exposed from the resin portion to the bottom surface of the recess portion. The recess portion is defined such that the metal wiring is widely exposed at the bottom surface and the inner side surface of the recess portion is formed in a reverse truncated cone shape that tapers upward, so that light emitted from the light emitting element housed in the recess portion can be reflect efficiently.

The package substrate provided in the light emitting device described in JP 2007-235085A is manufactured such that a printed wiring board having a flat plate shape is attached to a mold, and a thermosetting resin composition for reflecting light is injected, then is molded by way of thermal pressure molding using a transfer mold apparatus. The package substrate is provided with a plurality of recess portions arranged in a matrix configuration to house a plurality of light emitting elements. The use of the lead frame in place of the printed wiring board is also described in JP 2007-235085A. Then, the optical semiconductor devices arranged in a matrix configuration are cut into individual optical semiconductor devices each having one LED element by dicing etc.

There has been known a technology capable of preventing occurrence of cracking in the bonding surface between the metal and resin at the time of dividing integrally molded semiconductor devices (for example, see JP2001-298144A). The package for semiconductor device described in JP 2001-297144A is a chip size package with bottom terminal in which, for example, an island having a semiconductor element such as a field effect transistor (FET) mounted thereon and leads for semiconductor element are sealed with a sealing body such as an epoxy resin. In the chip size package, the outer end of the island or lead is exposed at two opposite side surfaces of the sealed body and is not exposed at other two side surfaces which are perpendicular to the two side surfaces.

There has been a need for downsizing a light emitting device and for manufacturing a large number of the light emitting devices at once for reducing the cost. However, in the light emitting devices having a resin package provided with a recess portion for light emitting element, if burr occurs in the recess portion when the mold is removed, predetermined conditions determined by the size of the light emitting element to mount may not be fulfilled, which may make mounting of the light emitting element impossible. That is, in the case where formation of burr occurs by unnecessary resin remaining in the recess at a portion between a side surface and the bottom surface of the recess, a sufficient reserve region for mounting the light emitting element may not be maintained. Therefore, in order to cope with such problems, the package is needed to be designed with a size so that the light emitting element can be housed even in the case where burr remains in the recess portion. In this case, the overall size of the resin package may become unnecessarily large. Also, simply enlarging the size of the recess portion may result in a reduction of strength of the package.

Also, for example, the printed-wiring board and the lead frame used in the package substrate of the light emitting device described in JP 2007-235085A have a flat plate shape, and in the light emitting device, a thermosetting resin compact is disposed on the printed-wiring board and lead frame having a flat plate shape which results in a small bonding surface area. Therefore, problems arise such as that the lead frame or the like and the thermosetting resin compact can easily detach at the time of dicing, and that results in weak strength.

Also, for example, the semiconductor device described in JP 2001-298144A is capable of preventing occurrence of cracks in the bonding surface between the metal and the resin at the time of dividing the integrally molded semiconductor devices, but is not such a light emitting device provided with a recess in the resin package for housing the light emitting element. Therefore, conventional devices cannot cope with the case where the burr remains in the recess portion.

In the case where a light emitting device to obtain, for example, a red light emitting element, a green light emitting element, and a blue light emitting element may be housed in a single recess portion in the resin package. In other case, for example, a recess portion for a red light emitting element, a recess portion for a green light emitting element, and a recess portion for a blue light emitting element are defined in a single resin package. Accordingly, in the light emitting device having a resin package provided with a recess portion for light emitting element, a technique is needed for mounting a light emitting element in the recess at a small pitch and with high accuracy.
JP 2009-295883 A discloses a method for manufacturing LED chipmounting board before mounting a plurality of LED chips, the method including steps of: bending free ends of a lead frame by clamping the lead frame by using an upper die and a lower die for resin molding and filling a space (cavity) formed by the upper die and lower die with a resin while the lead frame is clamped by using the upper die and lower die.
JP 2004-274027 A discloses a semiconductor light emitting device and its manufacturing method, in which the semiconductor light emitting device comprises a lead frame with a main face, a LED chip, epoxy resin completely covering the LED chip, and a resin part enclosing the LED chip, and the epoxy resin has a top face, and the resin part has a top face of which distance from the main face is larger than that between the top face and the main face, and an inner wall which on the side of the LED chip extends in the direction apart from the main face to join to the top face.
US 2007/145403 A discloses a luminescent device including a die pad lead composed of an inner lead and an outer lead, a case for uniting the inner lead, a light emitting diode chip mounted on a first predetermined position of one main surface of the inner lead, and a transparent sealing material portion for sealing the light emitting diode chip and a part of the one main surface.
US 2008/224161 A1 discloses a semiconductor light emitting device and a multiple lead frame for the semiconductor light emitting device, in which the semiconductor light emitting device includes: a lead frame including a plate-like semiconductor light emitting element mounting portion having an LED chip mounted on a main surface, and a plate-like metal wire connecting portion extending over a same plane as the semiconductor light emitting element mounting portion; a metal wire electrically connecting the LED chip and the metal wire connecting portion; a thermosetting resin molded by die molding or dam-sheet molding so as to completely cover the LED chip and the metal wire; and a resin portion provided to surround the lead frame and having the thickness not greater than the thickness of the lead frame.

In view of the above problems, the present invention provides a light emitting device having a high strength resin package and capable of mounting a light emitting element with a small pitch and with high accuracy and a method of manufacturing the light emitting device.

The object above can be achieved by the features defined in the claims.
According to the present invention, a light emitting device according to claim 1 is provided.

The light emitting device of such structure has a first and a second leads disposed so as not to be exposed at two opposing side surfaces of the resin package but to be exposed at two other side surfaces which are perpendicular to the two side surfaces. This arrangement allows cutting of only the resin portion without cutting the leads at the time of cutting the side surfaces where the first and the second leads are not exposed from the resin package. Thus, detachment of the lead portion and the resin portion can be suppressed, and as a result, the strength of the resin package can be enhanced. The light emitting device of such structure has the first and the second leads exposed at the bottom surface of the recess portion of the resin package, and the regions forming the bottom surface of the recess portion are lower than their peripheral portions. Occurrence of burr can be suppressed by eliminating gaps between the lead frame, which is the material of the leads, and the mold. Even in the case where the burr occurs, the burr will be thin and will lack strength, so that such burr can be removed by performing a burr removing step using, for example, a blast treatment or water jet. Thus, burr can be prevented from remaining between the side surface and the bottom surface in the recess portion of the resin package. Accordingly, sufficient region etc. , for mounting the light emitting element can be secured in the bottom surface of the recess portion. Thus, the light emitting device has a strong resin package and the light emitting elements can be mounted with a small pitch and high accuracy.

Also in the light emitting device according to the present invention, the border portion connecting the bottom surface of the recess portion to the side surface of the recess portion preferably has a curved or beveled cross-sectional profile.

Also in the light emitting device according to the present invention, at the side surface of the recess portion of the resin package, the slope angle of the side surface of the recess portion of the resin portion and the slope angle of the side surface of the recess portion of the lead are preferably different.

Also in the light emitting device according to the present invention, at the side surface of the recess portion of the resin package, at least one of the side surface of the recess portion of the resin portion and the side surface of the recess portion of the lead is preferably formed with a rough surface. According to such structure, in the light emitting device, in addition to the effect of preventing the burr from remaining on the resin package, the bonding strength between the sealing member and at least one of the resin portion and the lead can be improved.

Also in the light emitting device according to the present invention, it is preferable that a gate mark is not formed on the outer side surface which to be a cutting surface of the resin portion of the resin package.

Also, in the light emitting device according to the present invention, the resin portion of the resin package is preferably made of a thermosetting resin.

Also, in the light emitting device according to the present invention, the light emitting element is preferably bonded to the bottom surface of the recess portion of the resin package by way of resin bonding or metal bonding. Here, for the bonding member, for example, a resin such as an epoxy, a silicone, a solder such as Au-Sn eutectic, or an electrically conductive paste such as Ag can be used.

In order to solve the problems described above, the present invention provides a method of manufacturing a light emitting device according to claim 8.

According to the steps described above, the method of manufacturing the light emitting device according to the present invention is such that, in the first step, a lead frame in which the leads to be used in the individual resin packages are connected is held between the upper molds and the lower molds, and in the second step, a resin is injected to mold a plurality of resin molded bodies each being integrally molded in the column direction. Here, the resin inlet port is provided at a position corresponding between the lead runners of the lead frame, so that a gate mark does not occur in each resin package and therefore the strength of the resin packages can be enhanced. The lead frame is formed beforehand such that each of a plurality of adjacent first leads arranged in a column direction is coupled to a respective branch of lead runner and each of a plurality of adjacent second leads arranged in the column direction is coupled to a respective branch of lead runner so that the leads are not present between the adjacent resin packages arranged in the column direction. Therefore, at the time of dividing into individual resin packages, cutting, for example, by means of dicing or laser beam or cutting by means of water jet, can be performed only on the resin portions. According to such steps, in the method of manufacturing the light emitting device, in the first step of holding the lead frame, the protruding portions formed in the upper mold are strongly pressed against the lead frame so that the regions in the top surfaces of the first and the second leads corresponding to the respective bottom surface of the recess portion of the resin packages can be made lower than their surrounding regions. With this arrangement, the positions of the first and the second leads with respect to corresponding resin portion in each resin package can be fit with high accuracy, and occurrence of variations in individual package can be prevented. There is also advantageous effect such that the burr is difficult to remain between the side surface and the bottom surface in each recess portion of the resin molded body, or that the burr is prevented from remaining between the side surface and the bottom surface, and accordingly, regions or the like for mounting each light emitting element can be sufficiently secured. Thus, the light emitting device has a high-strength resin package and the light emitting elements can be mounted at a small pitch and with high accuracy.

In order to solve the problems described above, the present invention provides a method of manufacturing a light emitting device according to claim 9.

According to the steps described above, the method of manufacturing the light emitting device according to the present invention is such that, in the first step, a lead frame, to which the leads to be used in the individual resin packages are connected and the regions in the top surfaces of the first leads and the second leads each corresponding to the bottom surface of the recess portion of the respective resin packages are formed lower than their peripheral portions, is held between the upper mold and the lower mold. In the second step, a resin is injected to obtain a plurality of resin molded bodies each integrally molded in a column direction. Here, the resin inlet port is provided at a position corresponding between the lead runners of the lead frame. Therefore, a gate mark does not occur in each resin package and therefore the strength of the resin packages can be enhanced. The lead frame is formed beforehand in such a manner that each of a plurality of adjacent first leads arranged in the column direction is coupled to a respective branch of a lead runner and each of a plurality of adjacent second leads arranged in the column direction is coupled to a respective branch of a lead runner so that the leads are not present between the adjacent resin packages arranged in the column direction. Therefore, at the time of dividing into individual resin packages cutting can be performed only on the resin portions. The lead frame is formed beforehand in which the regions corresponding to each of the recess portions are formed lower than their peripheral portions, so that positioning of the first and the second leads with respect to the resin portion of the respective resin packages can be positioned with high accuracy, and thus variation in each resin package can be prevented. In the resin molded body integrally formed in the column direction, the regions in the top surfaces of the first and second leads corresponding to the bottom surface of the recess portion of the resin packages are formed lower than their peripheral regions. With this arrangement, there is advantageous effect such that the burr is difficult to remain between the side surface and the bottom surface in each recess portion of the resin molded bodies, or that the burr can be prevented from remaining between the side surface and the bottom surface, and accordingly, regions or the like for mounting each light emitting element can be secured. Thus, the light emitting device has a strong resin package and the light emitting elements can be mounted with a small pitch and high accuracy.

The third step of the method of manufacturing light emitting device according to present invention includes a resin cutting step and a lead cutting step performed in each of the resin molded bodies which are integrally molded with the lead frame. In the resin cutting step, cutting in the row direction is performed on each of the resin molded bodies at the positions between the sets of the first and second leads adjacent in the column direction so that only the resin portion is cut in the row direction at the positions where the first and the second leads are not to be exposed at the cut surface. In the lead cutting step, at the positions between the plurality of resin molded bodies where the cuts were made in the row direction and at the positions where the branches of the lead runners are formed, cutting is performed to cut only the branch portions of the lead runners in the column direction to divide into individual resin packages. The resin cutting step and the lead cutting step are preferably performed in a predetermined sequence.

According to such steps, in the method of manufacturing the light emitting device, in the resin cutting step, in the resin molded bodies integrally molded with the lead frame, cutting in the row direction is performed on each of the resin molded body at the positions between the resin packages adjacent in the column direction so that only the resin portions are cut in the row direction. With this, only the resin portions are cut without cutting the lead frame portions, so that cutting speed can be increased. In the case where a dicing saw is used for cutting, the lifetime of the blade can be extended. According to such steps, in the method of manufacturing the light emitting device, in the lead cutting step, at the positions between the plurality of resin molded bodies cutting is performed to cut only the branch portions of the lead runners in the column direction to divide into individual resin packages . With this, only the branch portions of the read runners are cut so that cutting speed can be increased. In the case where a lead cutter is used for cutting, the lifetime of the blade can be extended.

According to the third step in the method of manufacturing the light emitting device according to the present invention, the lead cutting step is preferably performed after the resin cutting step. According to such steps in the method of manufacturing the light emitting device, in the resin cutting step, by cutting between the resin portions prior to cutting the leads, the warpage of the lead frame due to the heat history during the steps can be reduced. With this, warpage of the leads can be reduced, so that bonding of the light emitting element on the leads at the bottom surface of the recess portion of the resin packages can be facilitated.

With the light emitting device according to the present invention, at the time of dividing into individual resin packages, the lead and the resin portion are not easily detached and also burr can be prevented from occurring between the side surface and the bottom surface in the recess portion. Thus, the light emitting device has a strong resin package and the light emitting elements can be mounted with a small pitch and high accuracy.

According to the method of manufacturing the light emitting device according to the present invention, the positions of the first and the second leads with respect to the resin portion in each resin package can be adjusted with high accuracy to enhance adhesion therebetween, and the burr can be prevented from occurring between the side surface and the bottom surface in each recess portion of the resin molded body. Thus, each of the light emitting devices has a strong resin package and the light emitting elements can be mounted with a small pitch and high accuracy.

According to the method of manufacturing the light emitting device of the present invention, a number of light emitting devices can be obtained in a short time and thus a significant improvement in the productivity can be achieved. Further, the amount of the runners to be disposed can be reduced, so that an inexpensive light emitting device can be provided.

The invention is described in detail in conjunction with the drawings, in which:
FIG. 1 is a perspective view showing a light emitting device according to a comparative example,
FIG. 2A is a top view, and FIGS. 2B and 2C respectively are a cross sectional view and a bottom view of the light emitting device taken along a line A-A of FIG. 1,
FIG. 3A is an enlarged cross sectional view of the light emitting device shown in FIG. 2B,
FIG. 3B is a cross sectional view of an example of the resin package according to the invention,
FIG. 3C is a cross sectional view of a resin package according to a comparative example,
FIG. 3D is a cross sectional view of an example of the resin package according to the invention,
FIG. 3E is a cross sectional view of an example of the resin package according to a comparative example,
FIG. 4 is a plan view showing a lead frame used in a method of manufacturing a light emitting device according to an embodiment of the present invention,
FIG. 5 is a plan view showing resin molded bodies integrally molded with the lead frame shown in FIG. 4,
FIGS. 6A and 6B are perspective views each showing a mold used for molding the resin molded body shown in FIG. 5, in which FIG. 6A shows an upper mold, and FIG. 6B shows a lower mold respectively,
FIG. 7 is a perspective view illustrating a state where a lead frame is mounted on the lower mold shown in FIG. 6,
FIGS. 8A through 8D are cross sectional views illustrating manufacturing steps of the light emitting device according to a comparative example,
FIGS. 9A and 9B are cross sectional views illustrating a step of interposing the lead frame between the upper mold and the lower mold, as a comparison with a conventional example, in which FIG. 9A illustrates a conventional step,
FIGS. 10A to 10C show jigs used in a step for dividing a plurality of light emitting devices sharing a lead frame into individual light emitting devices in the method of manufacturing according to the present invention,
FIG. 11 shows cutting lines used in a step for separating individual light emitting devices from the lead frame in the method of manufacturing according to the present invention, and
FIGS. 12A and 12B are each a partially enlarged view of FIG. 3D.

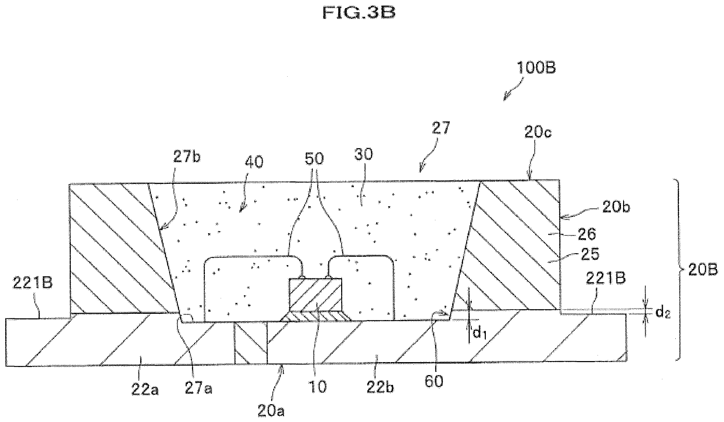

Hereinafter, embodiments of a method of manufacturing a light emitting device according to the present invention and embodiments of the light emitting device will be described in detail with reference to figures. Hereafter, only the "embodiments" relating to Figures 3B, 3D, 4 and 10A-12B describe embodiments of the invention, and all other "embodiments" merely refer to according to non-claimed comparative examples.

In the present specification, the term "lead", "resin portion", and "resin package" are used in the light emitting devices which are individually separated, and the term "lead frame" and "resin molded body" are used in the steps prior to individually separating the light emitting devices.

### Constitution of Light Emitting Device

### <Outline of Constitution of Light Emitting Device >

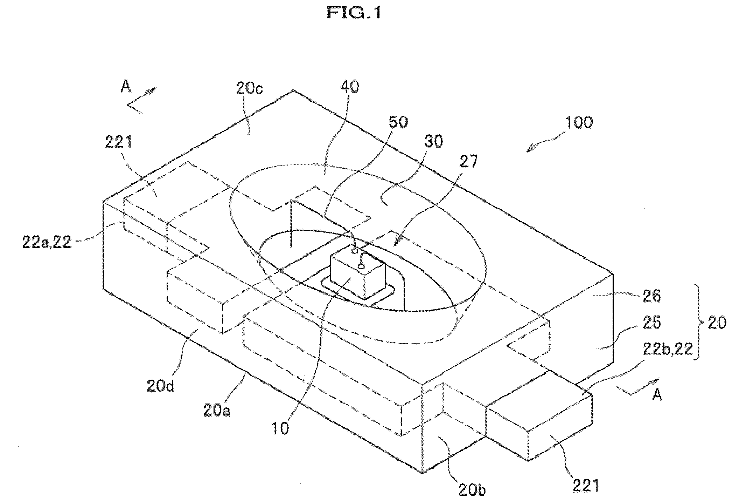

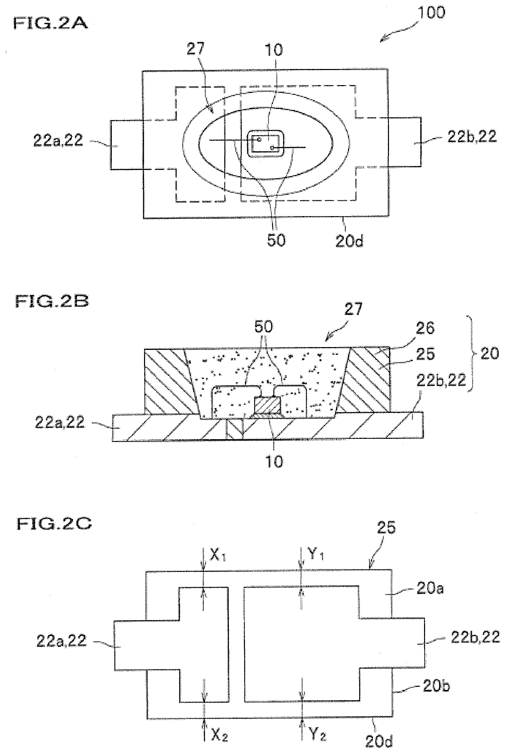

The light emitting device according tc the present embodiment will be described
below with reference to FIG. 1 and FIGS. 2A to 2C. As shown in FIG. 1, the light emitting device 100 has a resin package 20, a light emitting element 10 housed in the recess portion 27 of the resin package, and a light transmissive sealing member 30 filled in the recess portion 27 of the resin package to cover the light emitting element 10.

The resin package 20 mainly has leads 22a, 22b (hereinafter referred as lead 22 unless otherwise specified), and the resin portion 25 integrally molded with the lead 22. The resin portion 25 contains the light reflecting material 26. The resin package 20 has an outer bottom surface 20a on which the leads 22 are arranged, outer side surfaces 20b from each of which a part (exposed portion) 221 of the lead 22 is exposed, an outer top surface 20c defining a recess portion 27 opens upwardly, and outer side surfaces 20d from each of which the lead is not exposed.

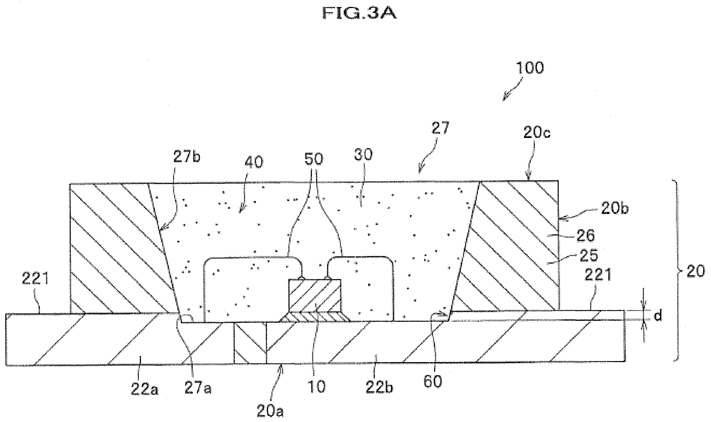

FIG. 2A is a top view, and FIGS. 2B and 2C respectively are a cross sectional view and a bottom view of the light emitting device 100 taken along a line A-A. An enlarged view of FIG. 2B is shown in FIG. 3A. As shown in FIG. 3A, the resin package 20 is provided with the recess portion 27 defined by the inner bottom surface 27a and the inner side surface 27b.

The top surface of the lead 22 (22a, 22b) is exposed at the inner bottom surface 27a of the recess portion 27 of the resin package 20 and the light emitting element 10 is mounted on the lead 22b. The sealing member 30 covering the light emitting element 10 is disposed in the recess portion 27. The sealing member 30 contains a fluorescent material 40. The light emitting element10 is electrically connected to the leads 22 through the wires 50 respectively. The lead 22 is not disposed on the outer top surface 20c of the resin package 20.

The resin package 20 has, as shown in FIG. 2A, leads 22a, 22b, which are not exposed from the opposing two outer side surfaces 20d but are exposed from the other opposing two outer side surfaces 20b which are perpendicular to the opposing two outer side surfaces 20d. The top surface of each of the leads 22a, 22b is exposed from the resin portion 25 at the inner bottom surface 27a of the recess portion 27. In the top surface of each of the leads 22a, 22b, a region constituting the bottom surface 27a of the recess portion 27 is formed lower than its peripheral region. That is, as shown by reference numeral 60 in FIG. 3A, a small step is provided at the top surface of each of the leads 22a, 22b so that the region constituting the inner bottom surface 27a of the recess portion 27 is lower than its peripheral region. Here, the height of the step is 0.01 µm or greater and 50 µm or less, preferably 0.05 µm or greater and 10 µm or less, further preferably 0.1 µm or greater and 5 µm or less.

### <Variation of package Structure>

An example of variation of the structure of the light emitting device and the resin package used therein will be described below with reference to the cross-sectional views of FIGS. 3A to 3D. The resin package 20 of the light emitting device 100 shown in FIG. 3A is such that, the step of the lead 22 is only provided at the region constituting the recess portion 27. However, according to the present invention as shown in the resin package 20B of the light emitting device 100B in FIG. 3B, the step is formed at the exposed portion 221B of the lead 22. The light emitting device 100B will be described later in the method of manufacturing.

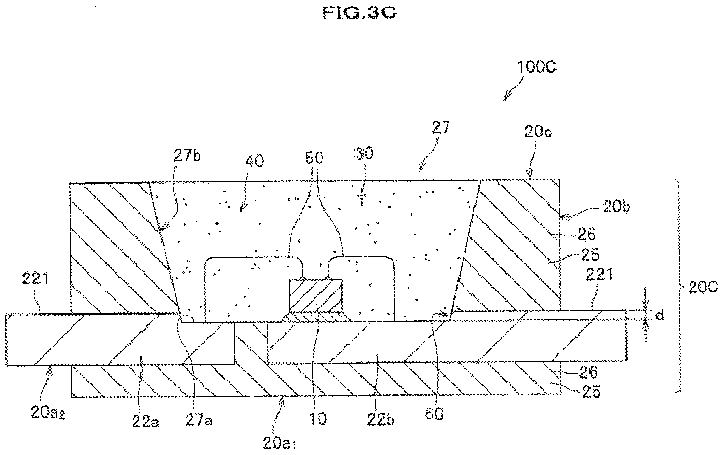

In the resin package 20 of the light emitting device 100 shown in FIG. 3A, the bottom surface of each of the leads 22a, 22b is exposed from the outer bottom surface 20a of the package so that the bottom surface 20a serves as the terminal portion. Alternatively, in another comparative example, as in the resin package 20c of the light emitting device 100C shown in FIG. 3C, the resin portion 25 can be formed at the bottom surface side of the lead 22. In this case, the bottom surface 20a₁ of the resin portion 25 projecting downward from the bottom surface 20a₂ of the lead serves as the outer bottom surface of the resin package 20C. The light emitting device 100C will be described later in the method of manufacturing.

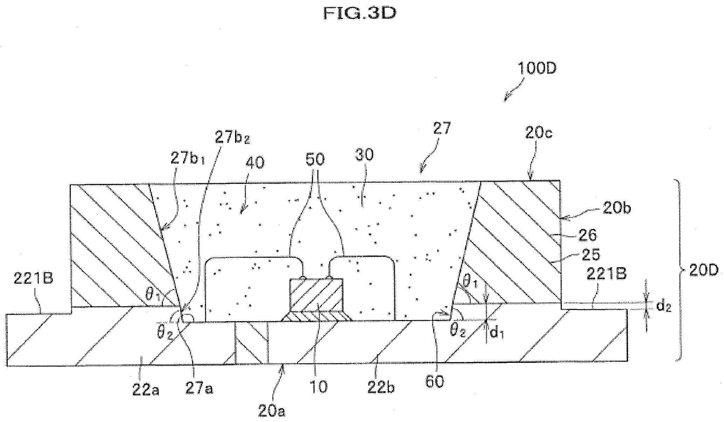

In the resin package 20 of the light emitting device 100 shown in FIG. 3A, as shown by reference numeral 60, the lead 22 and the resin portion 25 are on the same plane at the inner side surface 27b of the recess portion. However, according to the present invention, as in the resin package 20D of the light emitting device 100D shown in FIG. 3D, at the inner side surface 27b of the recess portion 27, the slope angle θ₁ of the inner side surface 27b₁ which is the side surface of the resin portion 25 and the slope angle θ₂ of the inner side surface 27b₂ which is the side surface of the lead 22 may have a different value. In this case, in order to reflect light efficiently, the inner side surface 27b₁ preferably has the slope angle 40°or greater and 90° or less. Also, In order to prevent burr from occurring at the bottom surface of the recess portion, the slope angle θ₂ is preferably greater than the slope angle θ₁, and more preferably close to perpendicular, but the slope angle θ₂ may be greater than the slope angle θ₂. The light emitting device 100D will be described later in the method of manufacturing.

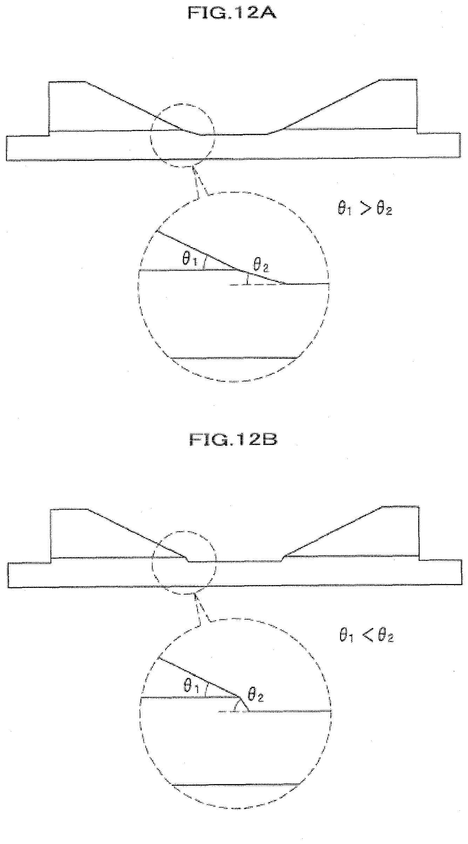

In detail, in the case as shown in FIG. 12A where the slope angle θ₁ is larger than the slope angle θ₂, the light emitted from the light emitting device can be efficiently reflected at the inner side surface 27b₂ to the light emitting surface side. With this arrangement, occurrence of burr can be suppressed and necessity of designing a light emitting device which allows for a residual burr can be eliminated. Accordingly, in addition to reducing the size of the package, a light emitting device with high light extracting efficiency can be obtained.

In the case as shown in FIG. 12B where the slope angle θ₁ is smaller than the slope angle θ₂, obtaining of anchor effect at the recess portion including the inner side surface 27b₂ can be facilitated, so that the detachment of the sealing resin from the frame can be prevented. Thus, a light emitting device capable of preventing detachment of the sealing resin while suppressing occurrence of burr can be obtained.

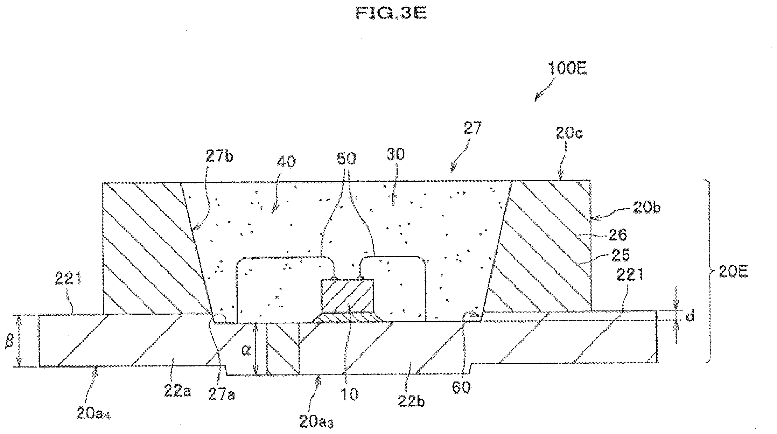

In the resin package 20 of the light emitting device 100 shown in FIG. 3A, the regions of the leads 22a, 22b constituting the recess portion 27 are formed thinner than the other regions, but alternatively, in another comparative example, as in the resin package 20D of the light emitting device 100E shown in FIG. 3E, the leads may be formed with a uniform thickness. Here, the thickness α of the region of the lead 22 constituting the recess portion 27 is different than the thickness β of the region of the lead 22 constituting the exposed portion 221. The light emitting device 100E will be described later in the method of manufacturing.

### <Structure of Each Component of Light Emitting Device>

### (Light Emitting Element)

For the light emitting element 10, a face-down structure may be employed as well as a face-up structure. The size of the light emitting element 10 is not specifically limited. A plurality of the light emitting elements 10 may be employed, in which all of them may be of the same kind, or may be of different kinds respectively exhibiting emission color of red, green, and blue, which are the components of three primary colors of light. For the light emitting element 10, one having an emission peak wavelength in the range of 350 nm to 800 nm can be used. Specifically, in the case where the light emitting device 10 made of a nitride-based semiconductor is used, one having the light emission peak wavelength within the short wavelength range of visible light in the range of 420 nm to 550nm is preferable.

The light emitting element 10 is bonded on the bottom surface 27a of the recess portion 27 of the resin package 20 by way of resin bonding or metal bonding. Examples of the bonding member bonding the light emitting element 10 includes, a resin such as an epoxy, a silicone, a solder material such as Au-Sn eutectic, an electrically conductive paste such as Ag, gold, paradium, and a brazing material such as a low melting point metal.

### (Resin Package)

The resin package 20 has excellent light resistance against light in the short wavelength range of 480 nm or shorter, and resistant to deterioration. Also, the resin package 20 has excellent heat resistance even when the light emitting element 10 generates heat due to application of electric current thereto.

For the resin package 20, a light transmissive resin with highly filled light reflective material 26 is preferably used. For example, a resin having light transmittance of 80% or greater at the wavelength range of 350 nm to 800nm is preferably used, and particularly, a resin having light transmissivity of 90% or greater is preferable. This is because, with a reduction in the amount of the light absorbed in the resin, deterioration of the resin package 20 can be suppressed. For the light transmissive resin, a thermosetting resin or a thermoplastic resin can be used, but a thermosetting resin is preferably used.

The resin package 20 has light reflectance of 70% or greater at the wavelength range of 350 nm to 800 nm, but preferably has light reflectance of 80% or greater at the wavelength range of 420 nm to 520 nm. It is also preferable to have high reflectance in the light emitting region of the light emitting element 10 and the light emitting region of the fluorescent material 40.

The outer shape of the resin package 20 is not limited to be an approximately rectangular prism, but may be an approximately cube, an approximately hexagonal pillar, or a many-sided shape. Also, in an external top view, a shape such as an approximately triangular shape, an approximately rectangular shape, an approximately pentagonal shape, or an approximately hexagonal shape can be employed. The height of the resin package 20 is not specifically limited, but 0.1 mm or greater is preferable.

### (Light Reflective Material)

The light reflective member 26 is preferably capable of reflecting light from the light emitting element 10 at a rate of 90% or more, and particularly preferably at a rate of 95% or more. The light reflective member 26 is preferably capable of reflecting light from the fluorescent material 40 at a rate of 90% or more, and particularly preferably at a rate of 95% or more. With a reduction in the amount of the light absorbed in the light reflective member 26, light extraction efficiency from the light emitting device 100 can be improved.

### (Recess Portion)

The recess portion 27 can be defined in various shapes, such as, when viewed from outer top surface 20c side, an approximately circular shape, an approximately oval shape, an approximately rectangular shape, an approximately polygonal shape, or a combination of those can be employed. The recess portion 27 is preferably defined by a reverse-tapered shape toward opening, but a cylindrical shape may be employed also. The inner side surface 27b of the recess portion 27 may be made with a smooth surface, but minute unevenness may be formed on the surface to scatter light. The recess portion 27 is defined with an inner side surface 27b. In detail, the inner side surface 27 is defined with, as shown in FIG. 3D, an inner side surface 27b₁ at the resin portion 25 side and an inner side surface 27b₂ at the lead 22 side. The slope angle of the inner side surface 27b₁ at the resin portion 25 side and the inner side surface 27b₂ at the lead 22 side may either be the same or different.

### (Lead)

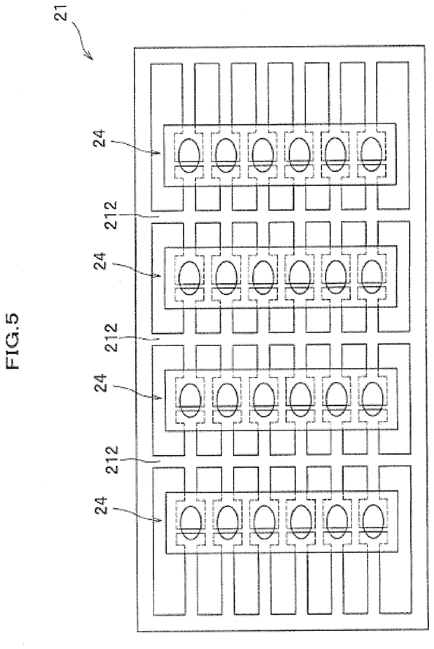

The leads 22a, 22b are disposed at a predetermined interval so as to be a positive and negative pair. Plating is applied on the portion of the leads 22 exposed at the inner bottom surface 27a of the recess portion and the portion of the lead 22 exposed at the outer bottom surface 20a of the resin package. The plating treatment can be performed before cutting out the resin molded body 24 (see FIG. 5), but it is preferable to use a lead frame which has been subjected to a plating treatment beforehand.

### (Resin Portion, Resin molded Body)

A triazine derivative epoxy resin is preferably used for the material of the resin portion 25 and the resin molded body 24 (see FIG. 5). The thermosetting resin may contain an acid anhydride, an antioxidant, a mold release agent, a light reflective member, an inorganic filler, a curing catalyst, a diffusing agent, a pigment, a fluorescent material, a reflective material, a light blocking material, a light stabilizer, or a lubricant. Titanium dioxide is used for the light reflective material and is contained in an amount of 10 to 60 wt%.

The resin package 20 is not limited by the embodiment described above, and a thermoplastic resin or a thermosetting resin may be preferably used. Among those, at least one kind selected from the group consisting of an epoxy resin, a modified epoxy resin, a silicone resin, a modified silicone resin, an acrylate resin, a urethane resin, and a phenol resin. Particularly, an epoxy resin, a modified epoxy resin, a silicone resin, or a modified silicone resin is preferable. For example, to 100 parts by weight of a colorless and transparent mixture prepared by mixing and dissolving the equivalent quantities of an epoxy resin compound of such as triglycidyl isocyanurate and hydrogenated bisphenol A triglycidyl ether and an acid anhydride composed of such as hexahydrophthalic anhydride, 3-methyl-hexahydrophthalic anhydride and 4-methyl-hexahydrophthalic anhydride, 0.5 parts by weight of DBU (1,8-diazabicyclo (5, 4, 0) undecene-7) as a curing accelerator, 1 part by weight of ethylene glycol as a co-catalyst, 10 parts by weight of titanium oxide pigment, and 50 parts by weight of a glass fiber are added and heat is applied to partially cure it to obtain a B-stage solid epoxy resin composition, and which is used for the resin package.

### (Sealing Member)

Material of the sealing member 30 is, for example, a thermoplastic resin or a thermosetting resin. Among the thermosetting resin, it is preferable to use at least one kind selected from the group consisting of an epoxy resin, a modified epoxy resin, a silicone resin, a modified silicone resin, an acrylate resin, and a urethane resin. Particularly, an epoxy resin, a modified epoxy resin, a silicone resin, a modified silicone resin are preferable. A rigid material is preferable for the sealing member to protect the light emitting element.

Also, a resin excellent in thermo-resistance, weather-resistance, and light resistance is preferably used for the sealing member 30. In order to render a specific function to the sealing member 30, at least one kind selected from the group consisting of a filler, a diffusing agent, a pigment, a fluorescent material, and a reflective material may be mixed in the sealing member. A diffusing agent may be contained in the sealing member 30. Examples of the diffusing agent include barium titanate, titanium oxide, aluminum oxide, and silicon oxide, which can be used preferably. In order to eliminate undesired wavelengths, an organic or inorganic coloring dye or coloring pigment can be contained in the sealing member 30. Moreover, a fluorescent material 40 capable of absorbing light from the light emitting element 10 and converting its wavelength can also be contained in the sealing member 30.

### (Lead Frame)

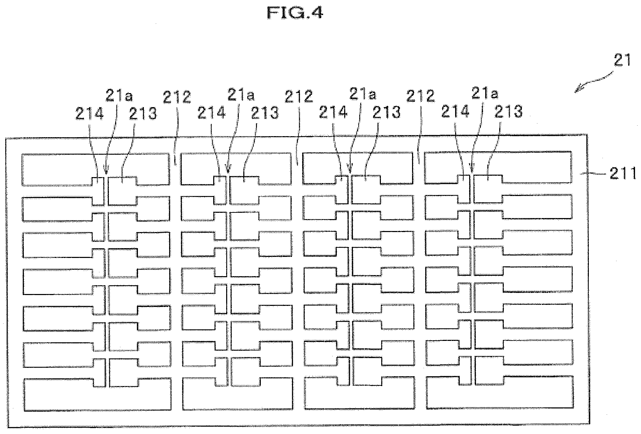

FIG. 4 is a plan view showing a lead frame used in a method of manufacturing a light emitting device according to an embodiment of the present embodiment. A flat metal sheet can be used for the lead frame 21, but a metal sheet provided with a step or an irregularity can also be used. The thickness of the lead frame 21 is not specifically limited, and may be, for example, 0.1 mm or greater and 1 mm or smaller.

The lead frame 21 is typically made by punching or by etching a flat metal sheet. Punching can be carried out with high dimensional precision and production of lead frame can be carried out at a low cost. An irregularity is formed in a cross-sectional shape in a lead frame with etching so that adhesion with the resin molded body can be improved. Particularly, in the case where a thin lead frame is used, a step and/or an irregular shape is formed at the time of punching to improve adhesive with the resin molded body. However, such a step and/or an irregular shape is too small to obtain sufficient improvement in the adhesion. Both the punching and etching may be employed. But, surface irregularity can be formed in all the cross-sectional portions (etched portions) of the etching processed lead frame. Therefore, the joining area of the lead frame and the resin molded body can be enlarged and thus a resin package with greater adhesion can be formed.

Etching processing does not employ a mold for punching and in the case where a large number of the resin packages to be supplied from one lead frame, the production cost of the lead frame per resin package can be reduced. Etching may be carried out so as to penetrate the lead frame, or may be carried out on one side so as not to penetrate.

The lead frame 21 includes an outer lead runner 211, a plurality of lead runners 212 extending in the column direction between two facing sides of the outer lead frame, and a plurality of first lead pieces 213 and second lead pieces 214 each coupled to respective branches of the lead runners 212. The first lead pieces 213 and the second lead pieces 214 are formed in conformity with the respective leads 22a, 22b used in the individual resin packages 20.

A plurality of pairs of the first lead piece 213 and the second lead piece 214 are provided in matrix on the lead frame 21. In this specification, the direction in which the first lead pieces 213 and the second lead pieces 214 are arranged spaced apart at the interval of the cut-out portion 21a is indicated as the low direction. The lead frame 21 is formed such that a plurality of the lead runners 212 arranged in the row direction and integrally formed.

The first lead pieces 213 adjacent in the column direction are respectively coupled to the plurality of branches extending in one direction from the lead runner 212. The second lead pieces 214 adjacent in the column direction are respectively coupled to the plurality of branches extending in the other direction from the lead runner 212.

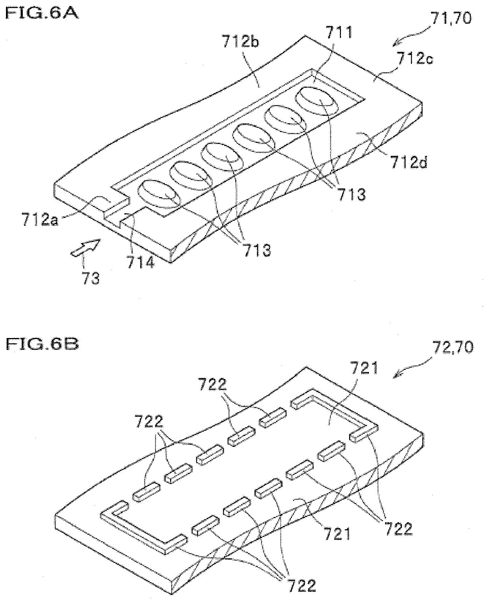

The lead frame 21 is made by using a good electric conductor such as iron, phosphor bronze, and a copper alloy. Moreover, in order to enhance the reflectivity of light from the light emitting element 10, metal plating such as silver, aluminum, copper, or gold can be applied. Metal plating is preferably applied on the lead frame before holding it between the upper mold 71 (see FIG. 6) and the lower mold 72 (see FIG. 6) at a timing such as after providing the cut-out portion 21a or after performing etching, but metal plating may be applied before the lead frame 21 is integrally molded with a thermosetting resin.

### Method of Manufacturing Light Emitting Device

### <Outline of Method of Manufacturing Light Emitting Device>

The method of manufacturing the light emitting device 100 shown in FIG. 1 mainly includes a step of preparing the lead frame 21 shown in FIG. 4 and holding the lead frame 21 between the upper mold and the lower mold, a step of transfer molding a resin in the mold cavity defined between the upper mold and the lower mold to mold an array of a plurality of resin molded-bodies 24 integrally in one body in the column direction of the lead frame 21, and a step of dicing the body in the row direction (resin cutting step), and a step of lead-cutting (lead cutting step) in the column direction. An example of the resin molded body 24 formed integrally with the lead frame 21 is shown in FIG. 5.

First, the mold used for transfer-molding will be described below. The mold 70 shown in FIGS. 6A and 6B includes the upper mold 71 and the lower mold 72. The upper mold 71 shown in FIG. 6A defines an array of spaces each being in conformity to the shape of the resin portion 25 (see FIG. 1) of the light emitting device 100 connected in one space in the array direction, each of the array of spaces being arranged corresponding to a position between the lead runners 212 of the lead frame 21, and has a plate shape main body portion 711 constituting the top portion (under side in FIG. 6A) of the FIG. 6A, an outer wall portion 712 formed in a frame shape from the end portion of the main body portion 711, a plurality of protruded portions 713 protruded from the main body portion 711, and an inlet port 714 which penetrates through a part of the outer wall portion 712 in horizontal direction.

The outer wall portion 712 is protruded perpendicular from the end portion of the main body portion 711, and includes a first outer wall portion 712a, a second outer wall portion 712b, a third outer wall portion 712c, and a fourth outer wall portion 712d, which are respectively to form a first outer side surface, a second outer side surface, a third outer side surface, and a fourth outer side surface of the resin molded body. In this example, the inlet port 714 is defined in the first outer wall portion 712a. The outer wall portion 712 is a portion to form the outer contour of the resin molded body, and formed in a rectangular shape in plan view. The shape of the outer wall portion 712 may be appropriately formed according to a desired shape of the resin molded body.

The protruded portion 713 is a portion to be in contact with the lead frame 21 at the time of transfer molding. Therefore, preventing the resin from flows into the contacting portion enables to form the exposed portion where a part of the lead frame 21 is exposed from the resin molded body. The protruding portions 713 are formed protruding downward (upward in FIG. 6A) from the body portion 711 and surrounded by the outer wall portion 712. Each of the protruding portions 713 is formed so as to be between the lead runners 121 of the lead frame 21 and is corresponding to the recess portion 27 of each of the resin packages. The protruding portions 713 are formed so that the portions to be in contact with the lead frame 21 are made flat. In order to define the recess portions 27 efficiently per unit of area in the upper surface of the resin molded body 24, the protruding portions are formed in one direction at equal intervals, and protruding portions 713 are protruding perpendicularly with respect to the one direction and at equal intervals.

The inlet port 714 is provided to inject a resin, and is defined in a bottom edge of approximately center (top edge in FIG. 6A) in the first outer wall portion 712a, and penetrating in the horizontal direction. The shape of the inlet port 714 may be defined in a semi-circular shape in cross section and narrowing from the inlet portion toward outlet portion of the inlet port 714.

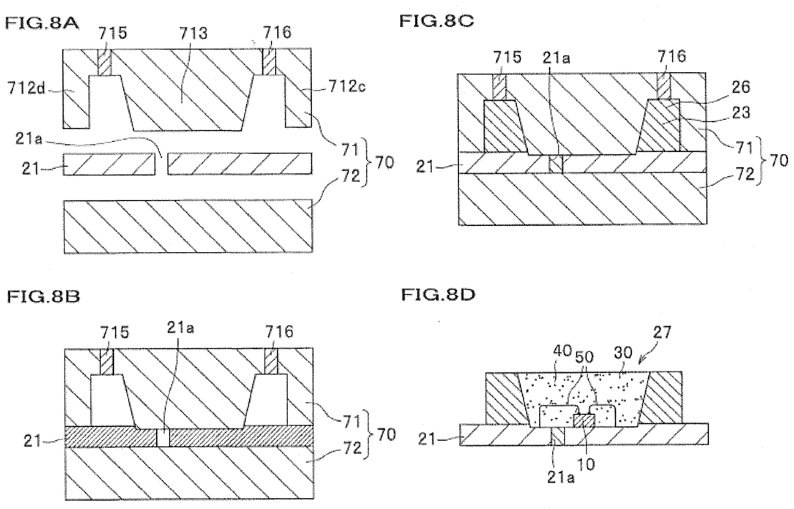

Although not shown in FIG. 6, a hole for inserting a pin is provided through the main body 711 in the upper portion of the upper mold 71. The hole for inserting a pin is a hole to insert the eject pin 715, 716 (see FIG. 8) at the time of removing the resin molded body 24 from the upper mold 71.

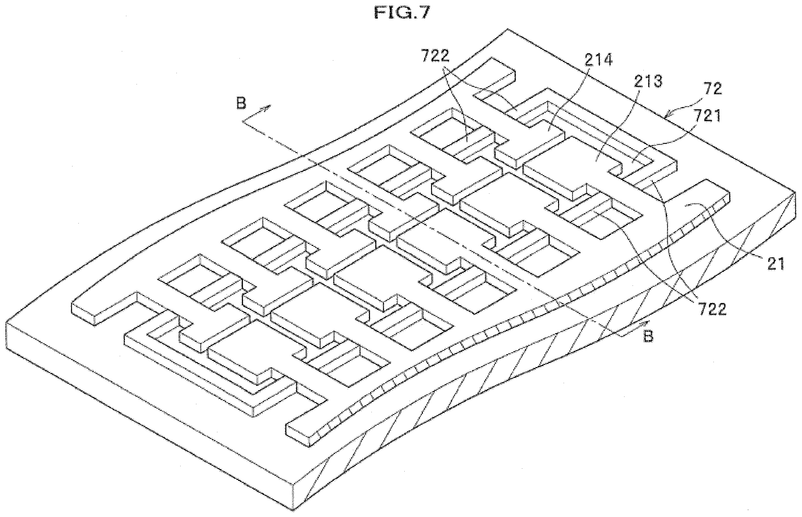

The lower mold 72 shown in FIG. 6B is in conformity to the upper mold 71 and has a plate shape main body portion 721 having a predetermined thickness and a flat surface and a plurality of protruding portions 722 protruded from the main body 721. The protruding portions 722 of the lower mold 72 are for contacting the upper mold 71 to create the space. The region surrounded by the protruding portions 722 is designed so that the first lead pieces 213 and the second lead pieces 214 of the lead frame 21 shown in FIG. 4 are disposed and the branch portions of each of the lead runners 212 are respectively fit between the protruding portions. FIG. 7 shows the state that the lead frame 21 is fit in the lower mold 72.

Next, each step of manufacturing will be described below. In the step for setting the lead frame 21 to be held by the mold 70, the upper mold 71 shown in FIG. 6A is turned over with respect to the lower mold 72 shown in FIG. 7 to hold the lead frame 21 therebetween. The steps, from prior to holding the lead frame 21 by the mold 70 to removing the mold 70 are described below with reference to FIG. 8. FIGS. 8A through 8D are sectional views taken along a section line B-B of FIG. 7.

(First Step) A metal plating is applied on the lead frame 21 in advance. The lead frame 21 shown in FIG. 8A is disposed in the lower mold 72 and as shown in FIG. 8B, and the lead frame 21 is held between the upper fame 71 and the lower frame 72. A space is defined in the mold 70 by bringing the upper mold 71 and the lower mold 72 together.

At this time, the cutout portion 21a at a location where the recess portion 27 to be defined is arranged between the protruding portion 713 of the upper mold 71 and the lower frame 72 and a strong pressure is applied (coining) on the lead frame 21. As a result, at the top surfaces of the first lead piece 213 and the second lead piece 214, a region corresponding to the inner bottom surface 27a of the recess portion 27 of the resin package crushes and falls down and becomes slightly thinner than its surroundings. This arrangement enables to prevent flapping of the lead frame 21 at the cutout portion 21a and thus occurrence of burr can be reduced.

### (Second Step)

Next, as shown in FIG. 8C, a resin 23 containing a light reflective material 26 is injected in the space defined between the upper mold 71 and the lower mold 72 in the mold 70 from the inlet port 714 provided between the lead runners 212 in the upper mold 71, and predetermined temperature and pressure are applied to carry out transfer molding. With this, the resin molded bodies 24 are formed to the lead frame 21 in the column direction. Here, the portions of the lead frame 21 near the cutout portions 21a are held between the upper mold 71 and the lower mold 72, so that a flapping of the lead frame 21 can be prevented when the transfer molding of the resin 23 is carried out, and thus occurrence of burr at the inner bottom surface 27a of the recess portion 27 can be prevented.

Following the above, after curing the resin 23, the upper mold 71 is removed with pushing out the molded body (housing) by the eject pins 715, 716 shown in FIG. 8C, and then the lower frame 72 is removed from the lead frame. At this time, it is preferable that tentative curing is carried out in the mold 70 by applying a predetermined temperature, then removing out from the mold 70, main curing is carried out at a higher temperature than in the tentative curing.

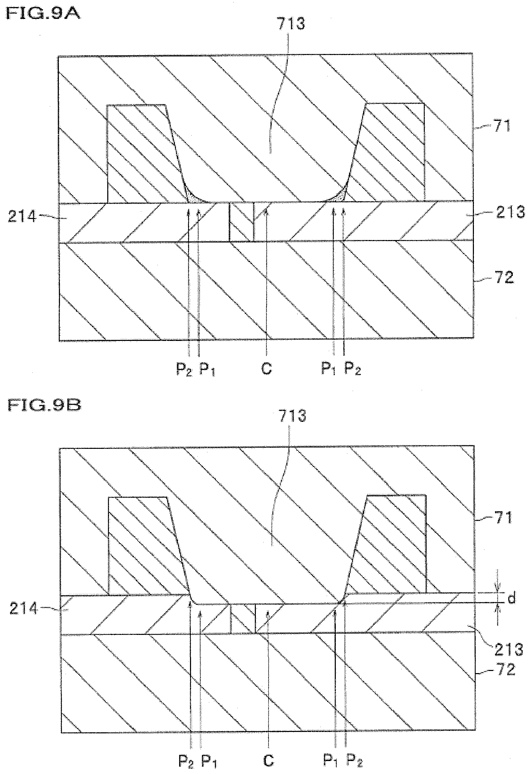

Here, the effect of reducing occurrence of burr will be described with reference to FIG. 9. FIG. 9 is an enlarged cross sectional view corresponding to FIG. 8C. FIG. 9A illustrates a comparative example where, in the first step, the lead frame 21 is not strongly pressed by the protruding portion 713 provided in the upper mold 71, and FIG. 9B illustrates a case where, in the first step, the lead frame 21 is strongly pressed by the protruding portion 713, respectively.

As shown in FIG. 9A, the protruding portion 713 of the upper mold 71 is brought into contact with the first lead piece 213 and the second lead piece 214 of the lead frame 21, and the resin is injected and cured. In this way, the protruding portion 713 and the lead frame 71 are closely contact with each other at the center C of the protruding portion 713, so that the burr does not remain. There is a narrow gap between the portion close to the circumference of the protruding portion 713 and the lead frame at the location P₁ which is a peripheral portion surrounding the center portion C of the protruding portion 713, so that burr may occur. However, the burr will be thin and thus will be easily removed by a simple burr removing step, or even without carrying out a burr removing step, such burr will be come out spontaneously.

However, at the location P₂ at the boundary between the inner side surface and the bottom surface of the recess portion, the resin was in contact with the edge portion of the protruding portion 713 and therefore the resin is formed thicker than the location P₁ where thin resin remains. Thus, burr would remain as shown by hatching with small dots in FIG. 9A. The reason is thought that, in the end portion of the mold, the periphery of the portion to be in contact with the lead is rounded, so that in the case where the surface of the lead is flat and pressing of the mold is insufficient, the periphery of the end portion of the mold may unsettle from the surface of the lead to leave a small gap and the resin may flow in the gap, resulting in formation of burr.

In contrast, in the present embodiment, the protruding portion 713 of the upper mold 71 is brought in contact with the first lead piece 213 and the second lead piece 214 of the lead frame 21 and coining is performed. At this time, the depth d at the center C of the protruding portion 713 shown in FIG. 9B is preferably 50 µm or less. Also, the depth d is preferably 0.01 µm or greater. After the coining is completed, the resin is injected and cured, and the upper mold 71 is removed. At this time, burr does not remain at the center C of the protruding portion 713. Moreover, due to the coining, the gap does not remain in the location P₁ which is a peripheral portion surrounding the center portion C, so that burr does not remain. Further, at the location P₂ at the boundary between the inner side surface and the bottom surface of the recess portion, thin burr may remain due to a small gap left between the end portion of the protruding portion 713 and the lead frame. However, the occurrence is very few, and even if the remaining burr occurs, it will be thin and is easily removed.

Here, reliability improvement effect achieved by coining will be described with reference to FIG. 2C. As shown in FIG. 2C, the leads 22a, 22b are disposed at an inner side from the outer side surfaces 20d in bottom view, which is advantageous because the outer side surfaces 20d can be easily cut and thus facilitates obtaining the individual resin packages. However, depending on the shape of the bottom surfaces of the leads 22a, 22b and their relative size with respect to the resin, positional deviation of the leads may cause a problem. The term "positional deviation of the leads" in this specification means the variation in the dimensions X₁ and X₂ shown in FIG. 2C among the resin packages 20. Such problems may occur in the case where the mold 70 is simply bring to contact with the lead frame 21 and coining is not performed. However, in the present embodiment, the resin 23 is injected after fixing the lead frame 21 by way of coining, so that the dimensions X₁, X₂, Y₁, and Y₂ shown in FIG. 2C do not vary among the products.

Now, return to FIG. 8 to continue the description of the manufacturing steps. Following the second step in which the resin 23 is injected and cured, the steps below (third to fifth steps) to complete the light emitting device 100 can be performed through two different sequences of the steps. The first sequences of the steps is such that, following the second step, the third step of dividing the resin molded body 24 which is made of the cured resin 23 into individual resin package and the fourth step of mounting the light emitting element 10 in the recess portion 27 of the resin package can be performed in this order. In contrast, the second sequences of the steps is such that, following the second step, the fourth step of mounting the light emitting element 10 in the recess portion 27 of the individual resin package in the resin molded body 24 which is made of the cures resin 23, and the third step of dividing the resin molded body 24 having the light emitting elements 10 mounted into individual resin packages, can be performed in this order.

Here, in the fourth step, each light emitting element 10 is mounted on the corresponding lead frame 21 at the inner bottom surface 27a of the recess portion 27 defined in the resin package 20 or in the resin molded body 24, and is connected to the lead frame 21 through, for example, the wires 50 respectively. The light emitting element 10 may be mounted in face-down manner without using the wires. Following the fourth step, a step (fifth step) in which over the light emitting element 10, a light transmissive sealing member is injected in the recess portion 27 of the resin package and is cured to form the sealing member 39 is performed. The cross sectional view of the state after the fifth step is shown in FIG. 8D.

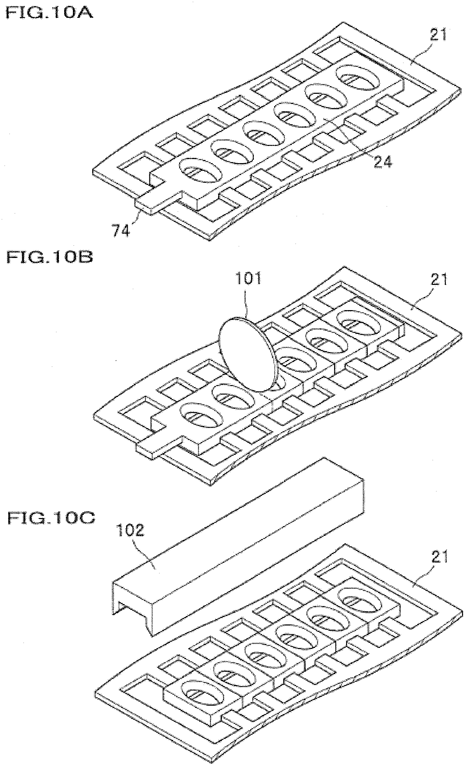

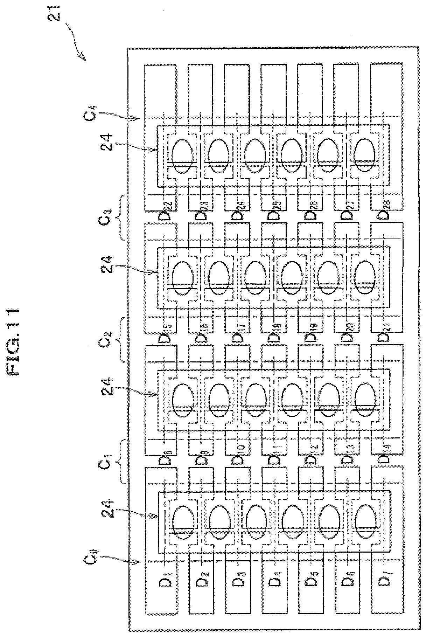

Now, as an example of the first sequence, the third step following the second step will be described with reference to FIG. 10 and FIG. 11. Here, as shown in FIG. 10A, the resin molded body 24 has integrally molded with the lead frame 21 in the second step. When it is removed from the mold, the gate 74 remains as the trace of the inlet port of the resin.

The third step includes a resin cutting step and a lead cutting step. In the resin cutting step, the resin molded body 24 integrally molded with the lead frame 21 is cut in the row direction at positions between the pairs each made of the first lead piece 213 and the second lead piece 214 which are adjacent in the column direction. The cutting method is such that, as shown in FIG. 10B, using, for example, a dicing saw 101, only the resin portion is cut from the resin molded body 24 (upper side in FIG. 10) side. That is, a cut in the row direction is made at each resin molded body 24. With this, the leads are not exposed at the cut surfaces and the surfaces corresponding to the outer side surfaces 20d (see FIG. 1) are formed. FIG. 11 shows the cuts D₁ to D₂₈ which are assumed to be made along the row direction in the resin molded body 24. Since the gate 74 shown in FIG. 10A will be removed by cutting which will be performed at D₇, D₁₄, D₂₁, and D₂₈ in FIG. 11, the gates are not shown in FIG. 11. With this, a gate mark does not remain on the surface of each resin package 20. In the resin cutting step, the resin molded body 24 may be cut by using laser beam or water jet as well as a dicing saw.

In the lead cutting step, following the resin cutting step, cutting is performed in the column direction at positions between the plurality of resin molded bodies 24 provided with cuts in the row direction and at positions where the branches of lead runners 212 present in the cut surfaces. The cutting method is such that, as shown in FIG. 10C, using, for example, a lead cutter 102, only the branch portions of the lead runners 212 are cut from the resin molded body 24 side. With this, individual resin packages 20 can be obtained. The leads are exposed at the cut surfaces thus obtained and the surfaces corresponding to the outer side surfaces 20b (see FIG. 1) are formed. FIG. 11 shows the cutting lines C₀ to C₄ along the column direction in the resin molded body 24. The cutting lines C1 to C3 indicate that cutting will be performed to the branch portions at the both sides of each of the lead runners. Alternatively, cutting may be performed to the branch portions of the lead runner at the both sides of each of the resin molded bodies 24.

### <Variation of Method of Manufacturing Light Emitting Device>

Now, as an example of method of manufacturing the light emitting device will be described with reference to the cross sectional views of FIG. 3B to FIG. 3D. The light emitting device 100B shown in FIG. 3B is provided with a step at both the region defining the recess portion 27 and the exposed portion of the lead 221B. At the time of manufacturing the light emitting device 100B, for example, the upper mold 71 which is a component of the mold 70 shown in FIG. 6 is prepared beforehand in such a way that the height of the protruding portion 713 which is in conformity to the shape of the recess portion is higher than the height of the second outer wall portion 712b and the fourth outer wall portion 712d. With the upper mold prepared beforehand as described above, even in the case where employing a mold of a type in which, at the time of holding the lead frame between the upper mold and the lower mold, a uniform pressure is applied regardless of the position of the lead frame, performing the first through the fifth steps in the same manner as described above, the resin package 20B of the light emitting device 100B can be easily manufactured.

With the method described above, not only suppression of the burr formation at the bottom surface of the recess portion 27 of the resin package 20B, but also suppression of the burr formation at the lower side of the outer side surfaces 20b of the resin package 20B can be achieved. According to the invention, in order to prevent formation of the burr in the bottom surface of the recess portion 27 of the resin package 20B, as shown in FIG. 3B, the height d₁ of the step provided in the region defining the recess portion 27 is greater than the height d₂ of the step provided at the exposed portion 221B of the lead 22.

The light emitting device 100 shown in FIG. 3C has a resin portion 25 formed also at the bottom surface side of the lead 22. At the time of manufacturing the light emitting device 100C, for example, the lower mold 72 which is a component of the mold 70 shown in FIG. 6 is prepared beforehand in such a way that the lower mold 72 defines cavity in conformity to the resin portion 25 at the bottom surface side of the lead 22. Then, the lead frame is held between the upper mold and the lower mold defining the cavity and the first through the fifth steps are performed in the same manner as described above, thus, the resin package 20C of the light emitting device 100C can be easily manufactured.

In the light emitting device 100D shown in FIG. 3D, at the inner side surface 27b of the recess portion 27, the slope angle θ₁ of the inner side surface 27b₁ which is the side surface of the resin portion 25 and the slope angle θ₂ of the inner side surface 27b₂ which is the side surface of the lead 22 may be different value. At the time of manufacturing the light emitting device 100D, for example, the protruding portions 713 of the upper mold 71 which is a component of the mold 70 shown in FIG. 6 is prepared beforehand, which allows manufacturing of the light emitting device 100D in the same manner as in the light emitting device 100B. As shown in FIG. 3D, a step is provided at both of the region defining the recess portion 27 and the exposed portions of the lead 22.

In the light emitting device 100 according to the present embodiment, the leads 22a, 22b are provided so as not to be exposed at the outer side surfaces 20d but to be exposed respectively at the outer side surfaces 20b which is perpendicular to the outer side surfaces 20d. Thus, at the time of cutting the outer side surfaces 20d, only the resin portion can be cut without cutting the leads, witch enables to suppress detachment of the leads from the resin portion at the time of dicing, and as a result, the strength of the resin package can be enhanced. Also, in the light emitting device 100, the leads 22a, 22b are exposed at the inner bottom surface 27a of the recess portion of the resin package, and the region forming the inner bottom surface 27a of the recess portion is lower than its peripheral portions, thus formation of burr can be suppressed and the region or the like for mounting the light emitting element 10 can be sufficiently secured. Thus, the light emitting device 100 has a strong resin package 20 and the light emitting elements 10 can be mounted with a small pitch and high accuracy.

According to the method of manufacturing the light emitting device according to the present embodiment, in the first step, coining is carried such that the protruding portions 713 of the upper mold 71 is brought in touch with the first lead piece 213 and the second lead piece 214 of the lead frame 21. Accordingly, the position of the lead with respect to the resin portion can be adjusted with high accuracy and the adhesion therebetween can be enhanced in each resin package, and also formation of burr between the inner side surface and the bottom surface of each recess portion in the resin molded body can be suppressed. According to the method of manufacturing a light emitting device of the present embodiment, a number of light emitting devices can be obtained in a short time and thus a significant improvement in the productivity can be achieved. Further, the amount of the runner to be disposed can be reduced, so that an inexpensive light emitting device can be provided.

According to the present invention, in the method of manufacturing the light emitting device, in the first step, the coining is carried out with the protruding portions 713 of the upper mold 71 are brought in contact with the first lead pieces 213 and the second lead pieces 214 of the lead frame 21. In an alternative method of manufacturing according to the invention, a lead frame which is prepared beforehand so that the region being in conformity to the bottom surface of the recess portion of the resin package is lower than its peripheral portion is held in the first step, such that the same effect can be achieved without performing the coining. In this case, the lower region in the lead frame preferably has a depth d of 50 µm or less from its peripheral portions.

As described above, in the case using the lead frame which is prepared beforehand so that the region which is in conformity to the bottom surface of the recess portion of the resin package is lower than its peripheral portions, and not performing the coining, the light emitting device 100D shown in FIG. 3D can be manufactured easily. In this case, it is sufficient to prepare beforehand a lead frame formed with the lead 22 with the slope angle θ₂ of the inner side surface 27b₂ which forms the inner side surface of the lead 22 at a predetermined angle, and also to adjust each protruding portion 713 of the upper frame 71 to be in conformity with the slope angle θ₁ of the inner side surface 27b₁ which forms the inner side surface of the resin portion.

Here, by forming the light emitting device 100D such that, at the inner side surface of the recess portion 27 of the resin package 20D, the slope angle θ₁ of the side surface (inner side surface 27b₁) of the recess portion in the resin portion is smaller than the slope angle θ₂ of the side surface (inner side surface 27b₂) of the recess portion in the lead, occurrence of burr can be prevented. Also, by forming the light emitting device 100D such that, at the inner side surface of the recess portion 27 of the resin package 20D, the slope angle θ₁ of the side surface (inner side surface 27b₁) of the recess portion in the resin portion is larger than the slope angle θ₂ of the side surface (inner side surface 27b₂) of the recess portion in the lead, the burr formed in the resin package can be removed easily with using blast treatment or the like.

The light emitting device 100D shown in FIG. 3D is preferably such that at the recess portion 27 of the resin package 20D, an irregular shape is formed on the inner side surface 27b₁ which constitutes the side surface of the resin portion 25. With this arrangement, the surface roughness due to the irregular shape enables to improve the bonding strength of the resin portion 25 and the sealing member 30. Also, it is preferable that an irregular shape is formed on the inner side surface 27b₂ which constitutes the side surface of the lead 22. With this arrangement, the surface roughness due to the irregular shape enables to improve the bonding strength of the lead 22 and the sealing member 30. Here, the irregular shape may me formed either on the inner side surface 27b₁ or the inner side surface 27b₂, or on both.

Also, the lead frame which is prepared so that the region being in conformity to the bottom surface of the recess portion of the resin package is lower than its surrounding portion is not limited to that having the region being in conformity to the bottom surface of the recess portion of the resin package is formed thinner than its peripheral portion, and as in the resin package 20E of the light emitting device 100E shown in FIG. 3E, the portions of the lead frame which are to be the leads 22a, 22b may be prepared with a certain thickness. In manufacturing the light emitting device 100E, a lead frame is prepared to have a shape in plan view, for example, such as shown in FIG. 4 and a cross sectional shape formed as described below. That is, the lead frame is prepared such that the region being in conformity to the bottom surface of the recess portion of the resin package is lower than its surrounding portion, and also that the portions of the lead frame which are to be the leads 22a, 22b have a certain thickness. In manufacturing the light emitting device 100E, in the first step of holding the lead frame in the mold 70 shown in FIG. 6, coining is not performed and the second through fifth steps are carried out in the same manner. Thus, manufacturing of the resin package 20E of the light emitting device 100E can be facilitated. Further, the first step may be carried out such that the lead frame is arranged interposed between the upper mold and the lower mold, and at the time strongly pressed against the lead frame (coining), the leads 22a, 22b as shown in FIG. 3E are formed. This step may be such that, the recess portion of the lead is defined in the top surfaces of the leads 22a, 22b at the location to be the bottom surface 27a of the recess portion of the package, and a protruding portion 20a₃ protruding outward from the outer bottom surface 20a₄ of the lead is formed in conformity to the recess portion of the lead.

Also, in the method of manufacturing the light emitting device, in the third step, the lead cutting step is performed following the resin cutting step, but the resin cutting step may be performed following the lead cutting step. However, in the case where the steps are performed in this sequence, the warpage of the lead frame increases due to the heat history during the step. Therefore, it is preferable that, prior to cutting the leads, the portions between the resin portions are cut to reduce the stress between the resin portions, then the leads are cut.

As an example of the recess portion 27 of the resin package of the light emitting device, a shape in which the bottom surface 27a of the recess portion and the side surface 27b of the recess portion are connected by a straight line (connected at one point in cross sectional view), but the present invention is not limited thereto, the border portion connecting the bottom surface 27a of the recess portion to the side surface 27b of the recess portion may have a curved or beveled cross-sectional profile.

The light emitting device 100 may further be provided with a Zener diode as a protective element. The Zener diode may be mounted on the lead 22a at the inner bottom surface 27a of the recess portion or on the outer side surface 20b of the resin package, spaced apart from the light emitting element 10. On the contrary, the arrangement may be such that the Zener diode is mounted on the lead 22b at the inner bottom surface 27a of the recess portion and the light emitting element 10 is mounted on the lead 22b. A Zener diode with a side of 300 µm or greater can be used as well as a side of about 280 µm.

In the above, described is the light emitting device 100 in which a single light emitting element 10 is housed in one recess portion 27 of the resin package 20, but a red light emitting element, a green light emitting element, and a blue light emitting element may be housed. Also, a recess portion for a red light emitting element, a recess portion for a green light emitting element, and a recess portion for a blue light emitting element may be defined in a resin package 20. Even in such a case, the light emitting elements can be mounted in the recess portion of the resin package at a small pitch with high accuracy.

It is to be understood that although the present invention has been described with regard to preferred embodiments thereof, various other embodiments and variants may occur to those skilled in the art. The invention is defined by the appended claims.

Reference signs used in the description and drawings are listed as below:
10 light emitting element
20 (20B, 20C, 20D, 20E) resin package
20a outer bottom surface
20a₁ bottom surface of resin portion
20a₂ bottom surface of lead
20a₃ projecting portion of outer bottom surface
20a₄ outer bottom surface of lead
20b outer side surface
20c outer top surface
20d outer side surface
21 lead frame
21a cutout portion
211, 212 lead runner
213 first lead piece
214 second lead piece
22 (22a, 22b) lead
221 exposed portion
23 thermosetting resin
24 resin molded portion
25 resin portion
26 light reflective material
27 recess portion
27a inner bottom surface
27b inner side surface
27b₁ inner side surface
27b₂ inner side surface
30 sealing member
40 fluorescent material
50 wire
70 upper mold
71 upper mold
711 body portion
712 outer wall portion
713 protruding portion
714 inlet port
72 lower mold
721 body portion
722 protruding portion
74 gate
100, 100B, 100C, 100D, 100E light emitting device
101 dicing saw
102 lead cutter

## Claims

1. A light emitting device (100) comprising:
a resin package (20) provided with a recess portion (27) defined by a side surface (27b) and a bottom surface (27a);
a light emitting element (10) housed in the recess portion (27) of the resin package (20); and a light transmissive sealing member (30) filled in the recess portion (27) of the resin package(20) to cover the light emitting element (10);
wherein the resin package (20) has a first lead (22a) and a second lead (22b) which are disposed so as not to be exposed from two opposing outer side surfaces (20d) of the resin package (20) but are exposed from the other two opposing outer side surfaces (20b) of the resin package (20) which are perpendicular to the two opposing outer side surfaces (20d),
wherein the resin package (20) has a resin portion (25) integrally formed with the first and second leads (22a, 22b),
wherein the first and the second leads (22a, 22b) are disposed so that their top surfaces are exposed from the resin portion (25) on the bottom surface (27a) of the recess portion (27),
wherein the region of the top surfaces of the first lead and the second lead corresponding to the bottom surface (27a) of the recess portion (27) of the resin package (20) is lower than its surrounding region of the top surface of the first and the second lead (22a, 22b),
**characterized in that** the region of the top surfaces of the first lead (22a) and the second lead (22b) exposed from the other two opposing outer side surfaces (20b) of the resin package (20) is lower than the region of the top surfaces of the first lead (22a) and the second lead (22b) in contact with the resin portion (25), and
**in that** the region of the top surfaces of the first (22a) and the second lead (22b) corresponding to the bottom surface (27a) of the recess portion (27) of the resin package (20) is lower than the region of the top surfaces of the first lead (22a) and the second lead (22b) exposed from the other two opposing outer side surfaces (20b).

2. The light emitting device (100) according to claim 1, **characterized in that** a border portion connecting the bottom surface (27a) of the recess portion (27) to the side surface (27b) of the recess portion has a curved or beveled cross-sectional profile.

3. The light emitting device (100) according to claim 1 or claim 2, **characterized in that** at the side surface (27b) of the recess portion (27) of the resin package (20), a slope angle (θ₁) of the side surface (27b₁) of the recess portion (27) of the resin portion (25) and a slope angle (θ₂) of the side surface (27b₂) of the lead (22) are different.

4. The light emitting device (100) according to one of claims 1 to 3, **characterized in that** at the side surface (27b) of the recess portion (27) of the resin package (20), at least one of the side surface (27b₁) of the recess portion (27) of the resin portion (25) and the side surface (27b₂) of the recess portion (27) of the lead (22) has a rough surface.

5. The light emitting device (100) according to one of claims 1 to 4, **characterized in that** a gate mark is not formed in an outer side surface which is a cut surface of the resin portion (25) of the resin package (20).

6. The light emitting device (100) according to one of claims 1 to 5, **characterized in that** the resin portion (25) of the resin package (20) is made of a thermosetting resin.

7. The light emitting device (100) according to one of claims 1 to 6, **characterized in that** the light emitting element (10) is bonded to the bottom surface (27a) of the recess portion (27) of the resin package (20) by using resin bonding or metal bonding.

8. A method of manufacturing a light emitting device (100) according to any one of claims 1 to 7, the method comprising:
a first step of preparing a lead frame (21) integrally formed by, in a direction of arranging a first and a second leads (22a, 22b) spaced apart from each other to be used in individual resin packages (20) as a row direction, arranging a plurality of pairs of the first and the second leads (22a, 22b) in a matrix, coupling a plurality of first leads (22a) adjacent in column direction to a branch portion of corresponding lead runners (211, 212), and coupling a plurality of second leads (22b) adjacent in column direction to a branch portion of corresponding lead runners (211, 212), and arranging a plurality of the lead runners (211, 212) in the row direction and holding the lead frame (21) with an upper mold (71) defining a line of spaces each defined in a shape in conformity with the resin portion (25), provided with a protruding portion formed corresponding to the recess portion (27) of the individual resin package (20), with each space arranged between the plurality of lead runners (211, 212) of the lead frame (21), and a lower mold (72) formed in conformity to the upper mold (71),
a second step of molding a plurality of resin molded bodies integrally molded in column direction by injecting a resin in a mold cavity defined between the upper mold (71) and the lower mold (72) from an inlet port (714) provided in the upper mold (71) at a position corresponding between the lead runners (211, 212) to fill the spaces defined in the upper mold (71),
a third step of dividing the resin molded bodies (24) into individual resin packages (20),
a fourth step of mounting a light emitting element (10) in the recess portion (27) in the resin package (20) at either timing of between the second step and the third step or after the third step, and
a fifth step of forming a sealing member (30) by injecting a light transmissive sealing material in the recess portion (27) of the resin package (20) over the light emitting element (10),
wherein at the time of holding the lead frame (21) in the first step, a protruding portion (713) formed in the upper mold (71) being strongly pressed against the lead frame (21) so that a region of the top surfaces of the first lead (22a) and the second lead (22b) corresponding to the bottom surface (27a) of the recess portion (27) of the resin package (20) is made lower than its surrounding region,
wherein the upper mold (71) has an outer wall portion (712) having a frame shape surrounding the protruding portion (713) and comprising a first outer wall portion, a second outer wall portion, a third outer wall portion and a fourth outer wall portion to form respectively the first to fourth outer side surfaces (20b, 20d) of the resin package (20), and
wherein parts (221) of the first leads and the second leads (22a, 22b) are exposed from the second and the fourth outer side surfaces (20b, 20d) of the resin package (20), and
**characterized in that** before the first step, preparing the upper mold (71) beforehand in such a way that the height of the protruding portion (713) is higher than the height of the second and fourth outer wall portions of the upper mold (71) such that at the time of holding the lead frame (21) between the upper mold (71) and the lower mold (72), an uniform pressure is applied, and a light emitting device (100) according to any one of claims 1 to 7 can be manufactured.

9. A method of manufacturing a light emitting device (100) according to any one of claims 1 to 7,, the method comprising:
a first step of preparing a lead frame (21) integrally formed by, in a direction of arranging a first and a second leads (22a, 22b) spaced apart from each other to be used in individual resin packages (20) as a row direction, arranging a plurality of pairs of the first and the second leads (22a, 22b) in a matrix, coupling a plurality of first leads (22a) adjacent in column direction to a branch portion of corresponding lead runners (211, 212), and coupling a plurality of second leads (22b) adjacent in column direction to a branch portion of corresponding lead runners (211, 212), and arranging a plurality of the lead runners (211, 212) in the row direction, and forming a region of the top surfaces of the first leads (22a) and the second leads (22b) corresponding to the bottom surface (27a) of the recess portion (27) of the resin package (20) to be lower than their periphery, forming the region of the top surfaces of the first leads (22a) and the second leads (22b) corresponding to the portions of the first and second leads (22a, 22b) exposed from the outer side surfaces (20b, 20d) of the resin package (20) to be lower than the region of the top surfaces of the first leads (22a) and the second leads (22b) corresponding to the region of the top surfaces of the first leads (22a) and the second leads (22b) in contact with the resin portion (25), the region of the top surfaces of the first leads (22a) and the second leads (22b) corresponding to the bottom surface (27a) of the recess portion (27) of the resin package (20) being lower than the region of the top surfaces of the first leads (22a) and the second leads (22b) corresponding to the portions (221) of the first and second leads (22a, 22b) exposed from the other two opposing outer side surfaces (20b, 20d), then, holding the lead frame (21) with an upper mold (71) defining a line of spaces each defined in a shape in conformity with the resin portion (25), provided with a protruding portion (713) formed corresponding to the recess portion (27) of the individual resin package (20), with each space arranged between the plurality of lead runners (211, 212) of the lead frame (21), and a lower mold (72) formed in conformity to the upper mold (71), without coining the lead frame (21) with the protruding portion (713) of the upper mold,
a second step of molding a plurality of resin molded bodies (24) integrally molded in column direction by injecting a resin in a mold cavity defined between the upper mold (71) and the lower mold (72) from an inlet port (714) provided in the upper mold (71) at a position corresponding between the lead runners (211, 212) to fill the spaces defined in the upper mold (71),
a third step of dividing the resin molded bodies (24) in individual resin packages (20),
a fourth step of mounting a light emitting element (10) in the recess portion (27) in the resin package (20) at either timing of between the second step and the third step or after the third step, and
a fifth step of forming a sealing member (30) by, following the fourth step, injecting a light transmissive sealing material in the recess portion (27) of the resin package (20) over the light emitting element (10).

10. The method of manufacturing the light emitting device (100) according to claim 8 or claim 9, **characterized in that**
the third step of the method of manufacturing light emitting device (100) according to present invention includes a resin cutting step and a lead cutting step performed in each of the resin molded bodies (24) which are integrally molded with the lead frame (21), in the resin cutting step, cutting in the row direction is performed on each of the resin molded bodies (24) at the positions between the sets of the first and second leads (22a, 22b) adjacent in the column direction so that only the resin portion(25) is cut in the row direction at the positions where the first and the second leads (22a, 22b) are not to be exposed at the cut surface, in the lead cutting step, at the positions between the plurality of resin molded bodies (24) where the cuts were made in the row direction and at the positions where the branch of the lead runners (211, 212) are formed, cutting is performed to cut only the branch portion of the lead runner (211, 212) in the column direction to divide into individual resin packages (20), and the resin cutting step and the lead cutting step are performed in a predetermined sequence.

11. The method of manufacturing the light emitting device (100) according to claim 10, **characterized in that**, in the third step, the lead cutting step is performed after the resin cutting step.

## Patentansprüche

1. Lichtemittierendes Bauelement (100), mit:
einer Harzpackung (20), die einen Vertiefungsabschnitt (27) aufweist, der durch eine Seitenfläche (27b) und eine Bodenfläche (27a) definiert ist;
einem lichtemittierenden Element (10), das im Vertiefungsabschnitt (27) der Harzpackung (20) aufgenommen ist; und
einem lichtdurchlässigen Versiegelungselement (30), das in den Vertiefungsabschnitt (27) der Harzpackung (20) eingefüllt ist und das lichtemittierende Element (10) bedeckt,
wobei die Harzpackung (20) einen ersten Kontakt (22a) und einen zweiten Kontakt (22b) aufweist, die derart angeordnet sind, dass sie nicht von zwei gegenüberliegenden äußeren Seitenflächen (20d) der Harzpackung (20) freiliegen, aber von den anderen zwei gegenüberliegenden äußeren Seitenflächen (20b) der Harzpackung (20) freiliegen, die sich senkrecht zu den zwei gegenüberliegenden äußeren Seitenflächen (20d) erstrecken,
wobei die Harzpackung (20) einen Harzabschnitt (25) aufweist, der mit dem ersten und dem zweiten Kontakt (22a, 22b) integral ausgebildet ist,
wobei der erste und der zweite Kontakt (22a, 22b) derart angeordnet sind, dass ihre oberen Flächen vom Harzabschnitt (25) an der Bodenfläche (27a) des Vertiefungsabschnitts (27) freiliegen,
wobei der Bereich der oberen Flächen des ersten Kontakts und des zweiten Kontakts, der der Bodenfläche (27a) des Vertiefungsabschnitts (27) der Harzpackung (20) entspricht, niedriger ist als sein umgebender Bereich der oberen Fläche des ersten und des zweiten Kontakts (22a, 22b);
**dadurch gekennzeichnet, dass**
der Bereich der oberen Flächen des ersten Kontakts (22a) und des zweiten Kontakts (22b), der von den anderen zwei gegenüberliegenden äußeren Seitenflächen (20b) der Harzpackung (20) freiliegt, niedriger ist als der Bereich der oberen Flächen des ersten Kontakts (22a) und des zweiten Kontakts (22b), der mit dem Harzabschnitt (25) in Kontakt steht; und
dass der Bereich der oberen Flächen des ersten (22a) und des zweiten Kontakts (22b), der der Bodenfläche (27a) des Vertiefungsabschnitts (27) der Harzpackung (20) entspricht, niedriger ist als der Bereich der oberen Flächen des ersten Kontakts (22a) und des zweiten Kontakts (22b), der von den anderen zwei gegenüberliegenden äußeren Seitenflächen (20b) freiliegt.

2. Lichtemittierendes Bauelement (100) nach Anspruch 1, **dadurch gekennzeichnet, dass** ein Grenzabschnitt, der die Bodenfläche (27a) des Vertiefungsabschnitts (27) mit der Seitenfläche (27b) des Vertiefungsabschnitts verbindet, ein gekrümmtes oder abgeschrägtes Querschnittsprofil hat.

3. Lichtemittierendes Bauelement (100) nach Anspruch 1 oder 2, **dadurch gekennzeichnet, dass** an der Seitenfläche (27b) des Vertiefungsabschnitts (27) der Harzpackung (20) ein Neigungswinkel (θ₁) der Seitenfläche (27b₁) des Vertiefungsabschnitts (27) des Harzabschnitts (25) und ein Neigungswinkel (θ₂) der Seitenfläche (27b₂) des Kontakts (22) verschieden sind.

4. Lichtemittierendes Bauelement (100) nach einem der Ansprüche 1 bis 3, **dadurch gekennzeichnet, dass** an der Seitenfläche (27b) des Vertiefungsabschnitts (27) der Harzpackung (20) die Seitenfläche (27b₁) des Vertiefungsabschnitts (27) des Harzabschnitts (25) und/oder die Seitenfläche (27b₂) des Vertiefungsabschnitts (27) des Kontakts (22) eine raue Oberfläche hat.

5. Lichtemittierendes Bauelement (100) nach einem der Ansprüche 1 bis 4, **dadurch gekennzeichnet, dass** in einer äußeren Seitenfläche, die eine Schnittfläche des Harzabschnitts (25) der Harzpackung (20) ist, keine Angussstelle ausgebildet ist.

6. Lichtemittierendes Bauelement (100) nach einem der Ansprüche 1 bis 5, **dadurch gekennzeichnet, dass** der Harzabschnitt (25) der Harzpackung (20) aus einem wärmehärtbaren Harz besteht.

7. Lichtemittierendes Bauelement (100) nach einem der Ansprüche 1 bis 6, **dadurch gekennzeichnet, dass** das lichtemittierende Element (10) mit der Bodenfläche (27a) des Vertiefungsabschnitts (27) der Harzpackung (20) unter Verwendung einer Harzverbindung oder einer Metallverbindung verbunden ist.

8. Verfahren zum Herstellen eines lichtemittierenden Bauelements (100) nach einem der Ansprüche 1 bis 7, wobei das Verfahren aufweist:
einen ersten Schritt zum Herstellen eines Leadframe (21), der mit einer Anordnungsrichtung erster und zweiter Kontakte (22a, 22b), die voneinander beabstandet sind, so dass sie in individuellen Harzpackungen (20) verwendbar sind, als eine Reihenrichtung integral ausgebildet wird durch Anordnen mehrerer Paare der ersten und der zweiten Kontakte (22a, 22b) in einer Matrix, Verbinden mehrerer erster Kontakte (22a), die in einer Spaltenrichtung benachbart sind, mit einem Verzweigungsabschnitt entsprechender Trägerleisten (211, 212), Verbinden mehrerer zweiter Kontakte (22b), die in einer Spaltenrichtung benachbart sind, mit einem Verzweigungsabschnitt entsprechender Trägerleisten (211, 212), und Anordnen mehrerer der Trägerleisten (211, 212) in der Reihenrichtung und Halten des Leadframe (21) durch ein oberes Formteil (71), das eine Reihe von Räumen definiert, die jeweils in einer dem Harzabschnitt (25) entsprechenden Form definiert sind und jeweils einen Vorsprungabschnitt aufweisen, der entsprechend dem Vertiefungsabschnitt (27) der individuellen Harzpackung (20) ausgebildet ist, wobei jeder Raum, der zwischen den mehreren Trägerleisten (211, 212) des Leadframe (21) und einem unteren Formteil (72) angeordnet ist, in Übereinstimmung mit dem oberen Formteil (71) ausgebildet ist;
einen zweiten Schritt zum integralen Gießen mehrerer Harzgusskörper in einer Spaltenrichtung durch Einspritzen eines Harzes in einen Formhohlraum, der zwischen dem oberen Formteil (71) und dem unteren Formteil (72) definiert ist, über eine Einlassöffnung (714), die im oberen Formteil (71) an einer Position zwischen den Trägerleisten (211, 212) definiert ist, um die im oberen Formteil (71) definierten Räume zu füllen;
einen dritten Schritt zum Teilen des Harzgusskörpers (24) in individuelle Harzpackungen (20);
einen vierten Schritt zum Montieren eines lichtemittierenden Elements (10) im Vertiefungsabschnitt (27) der Harzpackung (20) zu einem beliebigen Zeitpunkt zwischen dem zweiten Schritt und dem dritten Schritt oder nach dem dritten Schritt; und
einen fünften Schritt zum Ausbilden eines Versiegelungselements (30) durch Einspritzen eines lichtdurchlässigen Versiegelungsmaterials in den Vertiefungsabschnitt (27) der Harzpackung (20) über dem lichtemittierenden Element (10),
wobei während des Haltens des Leadframe (21) im ersten Schritt ein im oberen Formteil (71) ausgebildeter Vorsprungabschnitt (713) stark gegen den Leadframe (21) gedrückt wird, so dass ein Bereich der oberen Flächen des ersten Kontakts (22a) und des zweiten Kontakts (22b), der der Bodenfläche (27a) des Vertiefungsabschnitts (27) der Harzpackung (20) entspricht, niedriger ist als sein umgebender Bereich,
wobei das obere Formteil (71) einen rahmenförmigen Außenwandabschnitt (712) aufweist, der den Vorsprungabschnitt (713) umgibt und einen ersten Außenwandabschnitt, einen zweiten Außenwandabschnitt, einen dritten Außenwandabschnitt und einen vierten Außenwandabschnitt aufweist, um jeweils die erste bis vierte äußere Seitenfläche (20b, 20d) der Harzpackung (20) zu bilden, und
wobei Teile (221) der ersten Kontakte und der zweiten Kontakte (22a, 22b) von der zweiten und der vierten äußeren Seitenfläche (20b, 20d) der Harzpackung (20) freiliegen; und
**dadurch gekennzeichnet, dass**
vor dem ersten Schritt das obere Formteil (71) derart bereitgestellt wird, dass die Höhe des Vorsprungabschnitts (713) höher ist als die Höhe des zweiten und des vierten Außenwandabschnitts des oberen Formteils (71), so dass während des Haltens des Leadframe (21) zwischen dem oberen Formteil (71) und dem unteren Formteil (72) ein gleichförmiger Druck ausgeübt wird und ein lichtemittierendes Bauelement (100) nach einem der Ansprüche 1 bis 7 hergestellt werden kann.

9. Verfahren zum Herstellen eines lichtemittierenden Bauelements (100) nach einem der Ansprüche 1 bis 7, wobei das Verfahren aufweist:
einen ersten Schritt zum Herstellen eines Leadframe (21), der mit einer Anordnungsrichtung erster und zweiter Kontakte (22a, 22b), die voneinander beabstandet sind, um in individuellen Harzpackungen (20) verwendet zu werden, als eine Reihenrichtung integral ausgebildet wird durch Anordnen mehrerer Paare der ersten und der zweiten Kontakte (22a, 22b) in einer Matrix, Verbinden mehrerer erster Kontakte (22a), die in einer Spaltenrichtung benachbart sind, mit einem Verzweigungsabschnitt entsprechender Trägerleisten (211, 212) und Verbinden mehrerer zweiter Kontakte (22b), die in einer Spaltenrichtung benachbart sind, mit einem Verzweigungsabschnitt entsprechender Trägerleisten (211, 212) und Anordnen mehrerer Trägerleisten (211, 212) in der Reihenrichtung und Ausbilden eines Bereichs der oberen Flächen der ersten Kontakte (22a) und der zweiten Kontakte (22b), die der Bodenfläche (27a) des Vertiefungsabschnitts (27) der Harzpackung (20) entsprechen, derart, dass er niedriger ist als seine Umgebung, Ausbilden des Bereichs der oberen Flächen der ersten Kontakte (22a) und der zweiten Kontakte (22b) entsprechend den Abschnitten der ersten und der zweiten Kontakte (22a, 22b), die von den äußeren Seitenflächen (20b, 20d) der Harzpackung (20) freiliegen, derart, dass er niedriger ist als der Bereich der oberen Flächen der ersten Kontakte (22a) und der zweiten Kontakte (22b), die dem Bereich der oberen Flächen der ersten Kontakte (22a) und der zweiten Kontakte (22b) entsprechen, die mit dem Harzabschnitt (25) in Kontakt stehen, wobei der Bereich der oberen Flächen der ersten Kontakte (22a) und der zweiten Kontakte (22b), der der Bodenfläche (27a) des Vertiefungsabschnitts (27) der Harzpackung (20) entspricht, niedriger ist als der Bereich der oberen Flächen der ersten Kontakte (22a) und der zweiten Kontakte (22b), der den Abschnitten (221) der ersten und der zweiten Kontakte (22a, 22b) entspricht, die von den anderen zwei gegenüberliegenden äußeren Seitenflächen (20b, 20d) freiliegen, anschließendes Halten des Leadframe (21) durch ein oberes Formteil (71), das eine Reihe von Räumen definiert, die jeweils in einer mit dem Harzabschnitt (25) übereinstimmenden Form definiert sind, das einen Vorsprungabschnitt (713) aufweist, der entsprechend dem Vertiefungsabschnitt (27) der individuellen Harzpackung (20) ausgebildet ist, wobei jeder Raum zwischen den mehreren Trägerleisten (211, 212) des Leadframe (21) und einem unteren Formteil (72) angeordnet ist, das in Übereinstimmung mit dem oberen Formteil (71) ausgebildet ist, ohne dass der Leadframe (21) durch den Vorsprungabschnitt (713) des oberen Formteils geprägt wird;
einen zweiten Schritt zum integralen Gießen mehrerer Harzgusskörper (24), in der Spaltenrichtung durch Einspritzen eines Harzes in einen Formhohlraum, der zwischen dem oberen Formteil (71) und dem unteren Formteil (72) definiert ist, über eine Einlassöffnung (714), die im oberen Formteil (71) an einer Position zwischen den Trägerleisten (211, 212) ausgebildet ist, um die im oberen Formteil (71) definierten Räume zu füllen;
einen dritten Schritt zum Teilen der Harzgusskörper (24) in individuelle Harzpackungen (20);
einen vierten Schritt zum Montieren eines lichtemittierenden Elements (10) im Vertiefungsabschnitt (27) in der Harzpackung (20) zu einem beliebigen Zeitpunkt zwischen dem zweiten Schritt und dem dritten Schritt oder nach dem dritten Schritt; und
einen fünften Schritt zum Ausbilden eines Versiegelungselements (30), in dem im Anschluss an den vierten Schritt ein lichtdurchlässiges Versiegelungsmaterial in den Vertiefungsabschnitt (27) der Harzpackung (20) über dem lichtemittierenden Element (10) eingespritzt wird.

10. Verfahren zum Herstellen eines lichtemittierenden Bauelements (100) nach Anspruch 8 oder Anspruch 9, **dadurch gekennzeichnet, dass**
der dritte Schritt des Verfahrens zum Herstellen eines lichtemittierenden Bauelements (100) gemäß der vorliegenden Erfindung einen Harzschneideschritt und einen Kontaktschneideschritt aufweist, die für jeden der Harzgusskörper (24) ausgeführt werden, die mit dem Leadframe (21) integral gegossen sind, wobei
im Harzschneideschritt ein Schneidvorgang in der Reihenrichtung für jeden der Harzgusskörper (24) an Positionen zwischen den Sätzen der ersten und der zweiten Kontakte (22a, 22b) ausgeführt wird, die in der Spaltenrichtung benachbart sind, so dass nur der Harzabschnitt (25) in der Reihenrichtung an den Positionen geschnitten wird, wo die ersten und die zweiten Kontakte (22a, 22b) an der Schnittfläche nicht freiliegen sollen,
im Kontaktschneideschritt an den Positionen zwischen den mehreren Harzgusskörpern (24), wo die Schnitte in der Reihenrichtung ausgeführt wurden, und an den Positionen, an denen die Verzweigung der Trägerleisten (211, 212) ausgebildet ist, ein Schneidvorgang ausgeführt wird, in dem nur der Verzweigungsabschnitt der Trägerleiste (211, 212) in der Spaltenrichtung geschnitten wird, um individuelle Harzpackungen (20) zu erhalten, wobei der Harzschneideschritt und der Kontaktschneideschritt in einer vorgegebenen Folge ausgeführt werden.

11. Verfahren zum Herstellen eines lichtemittierenden Bauelements (100) nach Anspruch 10, **dadurch gekennzeichnet, dass** im dritten Schritt der Kontaktschneideschritt nach dem Harzschneideschritt ausgeführt wird.

## Revendications

1. Dispositif électroluminescent (100) comprenant :
un boîtier en résine (20) muni d'une partie de renfoncement (27) définie par une surface latérale (27b) et une surface inférieure (27a) ;
un élément électroluminescent (10) contenu dans la partie de renfoncement (27) du boîtier en résine (20) ; et un élément d'étanchéité qui transmet la lumière (30) placé dans la partie de renfoncement (27) du boîtier en résine (20) afin de couvrir l'élément électroluminescent (10) ;
dans lequel le boîtier en résine (20) possède un premier fil (22a) et un second fil (22b) qui sont disposés de façon à ne pas être exposés depuis les deux surfaces latérales extérieures opposées (20d) du boîtier en résine (20), mais sont exposés depuis les deux autres surfaces latérales extérieures opposées (20b) du boîtier en résine (20) qui sont perpendiculaires aux deux surfaces latérales extérieures opposées (20d),
dans lequel le boîtier en résine (20) possède une partie en résine (25) intégralement formée avec le premier et le second fils (22a, 22b),
dans lequel le premier et le second fils (22a, 22b) sont disposés de sorte que leurs surfaces supérieures soient exposées depuis la partie en résine (25) sur la surface inférieure (27a) de la partie de renfoncement (27),
dans lequel la zone des surfaces supérieures du premier fil et du second fil correspondant à la surface inférieure (27a) de la partie de renfoncement (27) du boîtier en résine (20) est inférieure à sa zone environnante de la surface supérieure du premier et du second fils (22a, 22b),
**caractérisé en ce que** la zone des surfaces supérieures du premier fil (22a) et du second fil (22b) exposées depuis les deux autres surfaces latérales extérieures opposées (20b) du boîtier en résine (20) est inférieure à la zone des surfaces supérieures du premier fil (22a) et du second fil (22b) en contact avec la partie en résine (25), et
**en ce que** la zone des surfaces supérieures du premier (22a) et du second (22b) fils correspondant à la surface inférieure (27a) de la partie de renfoncement (27) du boîtier en résine (20) est inférieure à la zone des surfaces supérieures du premier fil (22a) et du second fil (22b) exposées depuis les deux autres surfaces latérales extérieures opposées (20b).

2. Dispositif électroluminescent (100) selon la revendication 1, **caractérisé en ce qu'**une partie de bord qui relie la surface inférieure (27a) de la partie de renfoncement (27) à la surface latérale (27b) de la partie de renfoncement possède un profil transversal incurvé ou biseauté.

3. Dispositif électroluminescent (100) selon la revendication 1 ou 2, **caractérisé en ce que**, au niveau de la surface latérale (27b) de la partie de renfoncement (27) du boîtier en résine (20), un angle de pente (θ₁) de la surface latérale (27b₁) de la partie de renfoncement (27) de la partie en résine (25) et un angle de pente (θ₂) de la surface latérale (27b₂) du fil (22) sont différents.

4. Dispositif électroluminescent (100) selon l'une des revendications 1 à 3, **caractérisé en ce que**, au niveau de la surface latérale (27b) de la partie de renfoncement (27) du boîtier en résine (20), au moins l'une de la surface latérale (27b₁) de la partie de renfoncement (27) de la partie en résine (25) et de la surface latérale (27b₂) de la partie de renfoncement (27) du fil (22) possède une surface rugueuse.

5. Dispositif électroluminescent (100) selon l'une des revendications 1 à 4, **caractérisé en ce qu'**une marque de grille n'est pas formée sur une surface latérale extérieure qui est une surface découpée de la partie en résine (25) du boîtier en résine (20).

6. Dispositif électroluminescent (100) selon l'une des revendications 1 à 5, **caractérisé en ce que** la partie en résine (25) du boîtier en résine (20) est composée d'une résine thermodurcissable.

7. Dispositif électroluminescent (100) selon l'une des revendications 1 à 6, **caractérisé en ce que** l'élément électroluminescent (10) est relié à la surface inférieure (27a) de la partie de renfoncement (27) du boîtier en résine (20) par une liaison en résine ou une liaison métallique.

8. Procédé de fabrication d'un dispositif électroluminescent (100) selon l'une quelconque des revendications 1 à 7, le procédé comprenant :
une première étape de préparation d'une grille de connexion (21) intégralement formée, dans une direction de placement d'un premier et d'un second fils (22a, 22b) espacés l'un de l'autre afin d'être utilisés dans des boîtiers en résine individuels (20) dans la direction horizontale ligne, en plaçant une pluralité de paires du premier et du second fils (22a, 22b) dans une matrice, en reliant une pluralité de premiers fils (22a) adjacents dans la direction verticale à une partie de ramification de passe-fils correspondants (211, 212), et en reliant une pluralité de seconds fils (22b) adjacents dans la direction verticale à une partie de ramification de passe-fils correspondants (211, 212), et en plaçant une pluralité de passe-fils (211, 212) dans la direction horizontale et en maintenant la grille de connexion (21) avec un moule supérieur (71) définissant une ligne d'espaces chacun définis selon une forme qui se conforme à la partie en résine (25), muni d'une partie en saillie formée en correspondance avec la partie de renfoncement (27) du boîtier en résine individuel (20), avec chaque espace disposé entre la pluralité de passe-fils (211, 212) de la grille de connexion (21), et un moule inférieur (72) formé en conformité avec le moule supérieur (71),
une seconde étape de moulage d'une pluralité de corps moulés en résine intégralement moulés dans la direction verticale en injectant une résine dans une cavité de moule définie entre le moule supérieur (71) et le moule inférieur (72) depuis un orifice d'admission (714) prévu dans le moule supérieur (71) à un emplacement situé entre les passe-fils (211, 212) afin de remplir les espaces définis dans le moule supérieur (71),
une troisième étape de séparation des corps moulés en résine (24) en boîtiers en résine individuels (20),
une quatrième étape de montage d'un élément électroluminescent (10) dans la partie de renfoncement (27) dans le boîtier en résine (20) à n'importe quel moment entre la seconde étape et la troisième étape ou après la troisième étape, et
une cinquième étape de formation d'un élément d'étanchéité (30) en injectant un matériau d'étanchéité qui transmet la lumière dans la partie de renfoncement (27) du boîtier en résine (20) par-dessus l'élément électroluminescent (10),
dans lequel, au moment du maintien de la grille de connexion (21) à la première étape, une partie en saillie (713) formée dans le moule supérieur (71) est fortement appuyée contre la grille de connexion (21) de sorte qu'une zone des surfaces supérieures du premier fil (22a) et du second fil (22b) correspondant à la surface inférieure (27a) de la partie de renfoncement (27) du boîtier en résine (20) soit inférieure à sa zone environnante,
dans lequel le moule supérieur (71) possède une partie de paroi extérieure (712) ayant une forme de cadre entourant la partie en saillie (713) et comprenant une première partie de paroi extérieure, une seconde partie de paroi extérieure, une troisième partie de paroi extérieure, et une quatrième partie de paroi extérieure afin de former respectivement la première à la quatrième surfaces latérales extérieures (20b, 20d) du boîtier en résine (20), et
dans lequel des parties (221) du premier fil et du second fil (22a, 22b) sont exposées depuis la seconde et la quatrième surfaces latérales extérieures (20b, 20d) du boîtier en résine (20), et
**caractérisé en ce que**, avant la première étape, le moule supérieur (71) est préparé à l'avance de sorte que la hauteur de la partie en saillie (713) soit supérieure à la hauteur de la seconde et de la quatrième parties de parois extérieures du moule supérieur (71) de sorte que, au moment du maintien de la grille de connexion (21) entre le moule supérieur (71) et le moule inférieur (72), une pression uniforme soit appliquée, et qu'un dispositif électroluminescent (100) selon l'une quelconque des revendications 1 à 7 puisse être fabriqué.

9. Procédé de fabrication d'un dispositif électroluminescent (100) selon l'une quelconque des revendications 1 à 7, le procédé comprenant :
une première étape de préparation d'une grille de connexion (21) intégralement formée, dans une direction de placement d'un premier et d'un second fils (22a, 22b) espacés l'un de l'autre afin d'être utilisés dans des boîtiers en résine individuels (20) dans la direction horizontale, en plaçant une pluralité de paires de premier et de second fils (22a, 22b) dans une matrice, en reliant une pluralité de premiers fils (22a) adjacents dans la direction verticale à une partie de ramification de passe-fils correspondants (211, 212), et en reliant une pluralité de seconds fils (22b) adjacents dans la direction verticale à une partie de ramification de passe-fils correspondants (211, 212), et en plaçant une pluralité de passe-fils (211, 212) dans la direction horizontale, et en formant une zone des surfaces supérieures des premiers fils (22a) et des seconds fils (22b) correspondant à la surface inférieure (27a) de la partie de renfoncement (27) du boîtier en résine (20) afin qu'elle soit inférieure à leur périphérie, en formant la zone des surfaces supérieures des premiers fils (22a) et des seconds fils (22b) correspondant aux parties des premiers et des seconds fils (22a, 22b) exposées depuis les surfaces latérales extérieures (20b, 20d) du boîtier en résine (20) de sorte qu'elle soit inférieure à la zone des surfaces supérieures des premiers fils (22a) et des seconds fils (22b) correspondant à la zone des surfaces supérieures des premiers fils (22a) et des seconds fils (22b) en contact avec la partie en résine (25), la zone des surfaces supérieures des premiers fils (22a) et des seconds fils (22b) correspondant à la surface inférieure (27a) de la partie de renfoncement (27) du boîtier en résine (20) étant inférieure à la zone des surfaces supérieures des premiers fils (22a) et des seconds fils (22b) correspondant aux parties (221) des premiers et des seconds fils (22a, 22b) exposées depuis les deux autres surfaces latérales extérieures opposées (20b, 20d), puis en maintenant la grille de connexion (21) avec un moule supérieur (71) définissant une ligne d'espaces chacun définis selon une forme conforme à la partie en résine (25), muni d'une partie en saillie (713) formée en correspondance avec la partie de renfoncement (27) du boîtier en résine individuel (20), avec chaque espace disposé entre la pluralité de passe-fils (211, 212) de la grille de connexion (21), et un moule inférieur (72) formé en conformité avec le moule supérieur (71), sans joindre la grille de connexion (21) à la partie en saillie (713) du moule supérieur,
une seconde étape de moulage d'une pluralité de corps moulés en résine (24) intégralement moulés dans la direction verticale en injectant une résine dans une cavité de moule définie entre le moule supérieur (71) et le moule inférieur (72) depuis un orifice d'admission (714) prévu dans le moule supérieur (71) à un emplacement situé entre les passe-fils (211, 212) afin de remplir les espaces définis dans le moule supérieur (71),
une troisième étape de séparation des corps moulés en résine (24) en boîtiers en résine individuels (20),
une quatrième étape de montage d'un élément électroluminescent (10) dans la partie de renfoncement (27) dans le boîtier en résine (20) à n'importe quel moment entre la seconde étape et la troisième étape ou après la troisième étape, et
une cinquième étape de formation d'un élément d'étanchéité (30), après la quatrième étape, en injectant un matériau d'étanchéité qui transmet la lumière dans la partie de renfoncement (27) du boîtier en résine (20) par-dessus l'élément électroluminescent (10).

10. Procédé de fabrication du dispositif électroluminescent (100) selon la revendication 8 ou 9, **caractérisé en ce que**
la troisième étape du procédé de fabrication du dispositif électroluminescent (100) selon la présente invention comprend une étape de découpe de résine et une étape de découpe de fil effectuées dans chacun des corps moulés en résine (24) qui sont intégralement moulés avec la grille de connexion (21), **en ce que**, à l'étape de découpe de résine, une découpe dans la direction horizontale est effectuée sur chacun des corps moulés en résine (24) aux emplacements situés entre les groupes de premiers et de seconds fils (22a, 22b) adjacents dans la direction verticale de sorte que seule la partie en résine (25) soit découpée dans la direction horizontale aux emplacements auxquels les premiers et les seconds fils (22a, 22b) ne doivent pas être exposés au niveau de la surface de découpe, **en ce que**, à l'étape de découpe de fil, aux emplacements situés entre la pluralité de corps moulés en résine (24) auxquels les découpes ont été effectuées dans la direction horizontale et aux emplacements auxquels la ramification des passe-fils (211, 212) sont formées, une découpe est effectuée afin de découper uniquement la partie de ramification du passe-fil (211, 212) dans la direction verticale afin de procéder à une séparation en boîtiers en résine individuels (20), et **en ce que** l'étape de découpe de résine et l'étape de découpe de fil sont effectuées dans un ordre prédéterminé.

11. Procédé de fabrication du dispositif électroluminescent (100) selon la revendication 10, **caractérisé en ce que**, à la troisième étape, l'étape de découpe de fil est effectuée après l'étape de découpe de résine.
